# EUROPEAN PATENT APPLICATION

(11) **EP 4 783 816 A2**
(43) Date of publication of application: **29.07.2026**
(21) Application number: 26184042.5
(22) Date of filing: 07.03.2024
(51) Int. Cl.: H10W 40/47

(54) **COOLING ASSEMBLIES AND SEMICONDUCTOR ASSEMBLIES, AND METHODS FOR PRODUCING COOLING ASSEMBLIES AND SEMICONDUCTOR ASSEMBLIES**

(30) Priority: 21.03.2023 EP 23163275
(62) Divisional of application: 24709874.2
(71) Applicant: Corintis SA, 1015 Lausanne (CH)
(72) Inventor: van ERP, Remco, 1006 Lausanne (CH); FAHRNI, Malik, 1018 Lausanne (CH); FRANCESCON, Andrea, 1206 Genf (CH)
(74) Representative: Fuchs Patentanwälte Partnerschaft mbB

(57) **Abstract**

According to the present invention there is provided a cooling assemblies for use as a heat sink in a semiconductor assembly, the cooling assemblies comprising, a manifold and one or more sub-coldplates which are attached to the manifold. There is further provided semiconductor assemblies which comprises any one of said cooling assemblies, wherein the sub-coldplates are in thermal contact with components which produce a heat flux which exceeds a predefined threshold heat flux and the manifold is in thermal contact with components which produce a heat flux which is below predefined threshold heat flux. There also provided a semiconductor assembly in which cooling channels are integral to the component. There is further provided methods of producing said cooling assemblies and semiconductor assemblies.

## Description

### Field of the invention

The present invention concerns a cooling assembly for use as a heat sink in a semiconductor assembly, the cooling assembly comprising, a manifold and one or more sub-coldplates which are attached to the manifold. There is further provided a semiconductor assembly which comprises the cooling assembly, wherein the sub-coldplates are in thermal contact with components which produce a heat flux which exceeds a predefined threshold heat flux and the manifold is in thermal contact with components which produce a heat flux which is below predefined threshold heat flux. There also another semiconductor assembly wherein in which cooling channels are integral to the component. There is further provided methods of producing said cooling assembly and semiconductor assemblies.

### Background to the invention

Since the early 2000s, each successive node size in semiconductor manufacturing resulted in an increase in heat generated per unit area. Extracting this heat is essential, as overheating of a semiconductor device negatively impacts device performance, efficiency and reliability: High temperatures lead to an increase in leakage currents, which result in power losses, an increase in sheet resistance due to self-heating degradation, and higher device temperature and temperature swings can be directly correlated to a reduction in the mean time before failure. In addition to silicon logic devices, such as CPU, GPU, TPU, FPGAs and other ASICs, this trend of rising heat fluxes and their negative impact on performance and reliability also holds for power electronic, optoelectronics and RF electronics, on silicon and other semiconductors such as GaAs, SiC, GaN, etc.

Fluid cooling using cold-plates is an established way to cool down these high-power integrated circuits and other semiconductor devices. A cold-plate is typically a metallic structure, made from a material with good thermal conductivity, such as copper, aluminum, or stainless steel. This cold plate is then brought in close contact with a heat-generating device. Heat conducts from the heat-generating device to the cold-plate, and a fluid flows through the cold-plate, and absorbs the heat through convective heat transfer. A plurality of features, such as fins and pins, is typically embedded inside the cold-plate to increase the surface area and heat transfer coefficient of this convective heat transfer process.

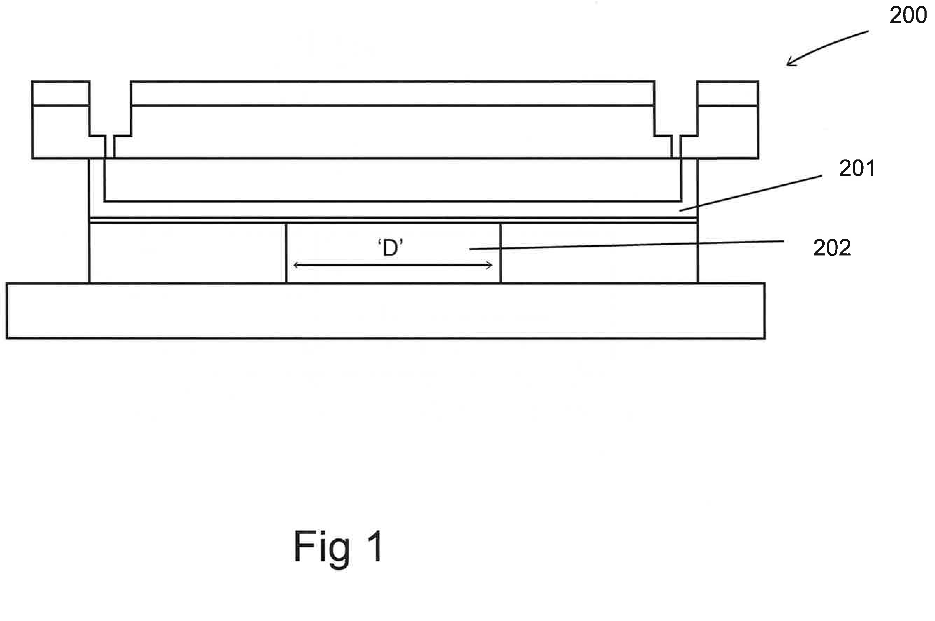

With developments in advanced packaging of semiconductor devices, integrated circuits with disaggregated dies, chiplets and tiles are becoming increasingly widespread. In some semiconductor assemblies, such as the assembly 200 shown in Figure 1, a single substrate may contain multiple silicon dies, or multiple interposers which contain multiple dies (multi-chip module). Individual dies may be separated by a significant distance 'D', and/or arranged in a non-rectangular pattern. As a result, the minimum size of a rectangular microfluidic cold plate 201 to cover all dies needs to match the minimum rectangular bounding box of all dies within the semiconductor assembly, including the empty space 202 between the dies where no heat is generated and no high-performance cooling is required - as shown in Figure 1. In addition, some dies within the assembly may not generate concentrated heat and thus do not require the high level of cooling that microfluidic cold-plates offer. Consequently, in existing cooling technologies much of the microfluidic cold-plate is unused and therefore unnecessary; in other words, disadvantageously, existing cooling technologies are not optimized for use with semiconductor assemblies which have disaggregated dies and/or have some dies which do not generate enough heat to require cooling. It follows that the production of such cooling technologies leads to wasted resources.

### Summary of the invention

An aim of the present invention to obviate or mitigate some of problems/disadvantages associated with existing cooling solutions.

According to the present disclosure there is provided a cooling assembly. Advantageously, in the present disclosure the surface area of microfluidic cold plates can be minimized to the areas that have the highest cooling requirements.

According to a further aspect of the present disclosure there are provided methods of producing a semiconductor assembly.

According to an aspect of the present invention as claimed there is provided a semiconductor assembly having the features recited in independent claim 1.

Another aspect of the present invention concerns a semiconductor assembly that comprises a chip assembly which comprises a PCB and a plurality of semiconductor components mounted on the PCB. The semiconductor assembly comprises a first and second semiconductor component, wherein the first semiconductor component may be known to produce a heat flux which is above a predefined threshold heat flux when the chip assembly is in use; and the second semiconductor component may be known to produce a heat flux which is below said predefined threshold heat flux when the chip assembly is in use. The first semiconductor component has an integral cooling plate defined by a layer with a cooling channel, along which cooling fluid can flow, wherein the first semiconductor component is formed in a substrate (e.g. a silicon substrate), and the cooling channel is defined in the said same substrate. In this way, the cooling plate and the first semiconductor component may be completely integrated in the same substrate (e.g. a silicon substrate).

This another aspect may in particular be combined with any of the appended dependent claims.

The dependent claims recite favourable features/steps of various embodiments of the invention.

### Brief description of the drawings

Exemplary embodiments of the invention are disclosed in the description and illustrated by the drawings in which:
Figure 1 illustrates one of the problems with existing cooling technologies;
Figure 2a illustrates longitudinal section view of a cooling assembly according to an embodiment of the present invention; Figure 2b shows a top view of a manifold used in the cooling assembly; Figure 2c shows a bottom view of the manifold; Figure 2d shows a top view of the cooling assembly; Figure 2e shows a cross sectional view taken along line A-A' of figure 2a;
Figure 3 illustrates a longitudinal section view of a semiconductor assembly according to an embodiment of the present invention;
Figure 4a illustrates a longitudinal section view of a cooling assembly according to an embodiment of the present invention; Figure 4b shows a top view of a manifold used in the cooling assembly; Figure 4c shows a bottom view of the manifold; Figure 4d shows a top view of the cooling assembly; Figure 4e shows a cross sectional view taken along line A-A' of figure 4a;
Figure 5 illustrates a longitudinal section view of a semiconductor assembly according to an embodiment of the present invention;
Figure 6a illustrates a longitudinal section view of a cooling assembly according to an embodiment of the present invention; Figure 6b shows a top view of a manifold used in the cooling assembly; Figure 6c shows a bottom view of the manifold; Figure 6d shows a top view of the cooling assembly; Figure 6e shows a cross sectional view taken along line A-A' of figure 6a;
Figure 7 illustrates a longitudinal section view of a semiconductor assembly according to an embodiment of the present invention;
Figure 8a illustrates a longitudinal section view of a cooling assembly according to an embodiment of the present invention; Figure 8b shows a top view of a manifold used in the cooling assembly; Figure 8c shows a bottom view of the manifold; Figure 8d shows a top view of the cooling assembly; Figure 8e shows a cross sectional view taken along line A-A' of figure 2a;
Figure 9 illustrates a longitudinal section view of a semiconductor assembly according to an embodiment of the present invention
Figure 10a illustrates a longitudinal section view of semiconductor assembly according to an embodiment of the present invention; Figure 10b shows a top view of a manifold used in the semiconductor assembly; Figure 10c shows a bottom view of the manifold; Figure d shows a top view of the semiconductor assembly 100; Figure 10e shows a cross sectional view taken along line A-A' of figure 10a.

### Detailed description of drawings

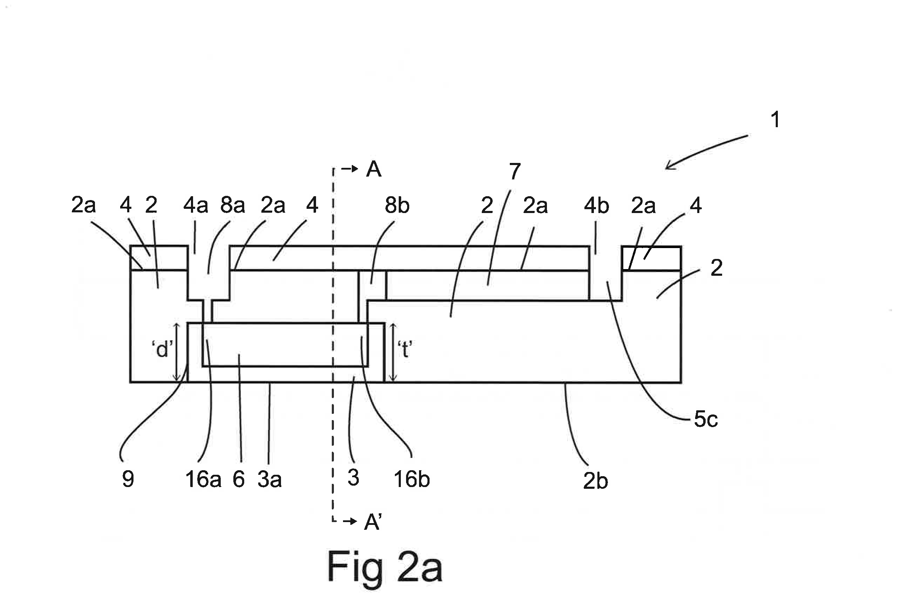

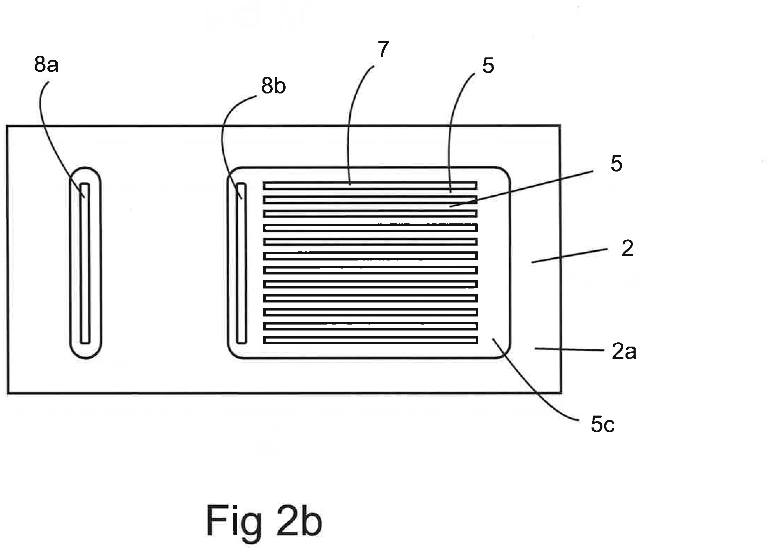

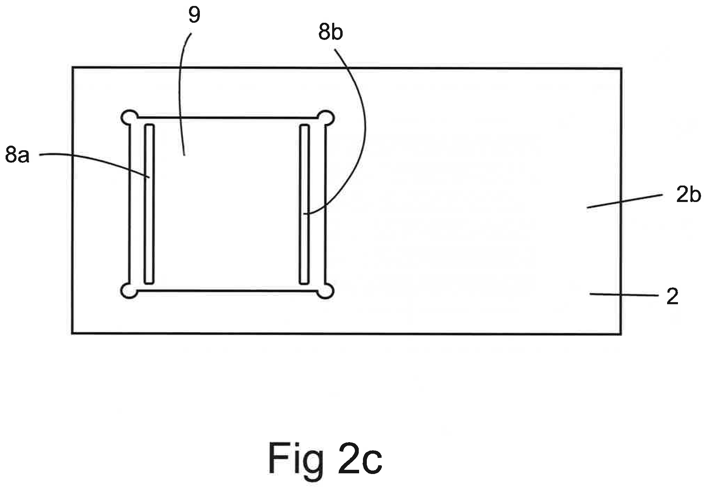

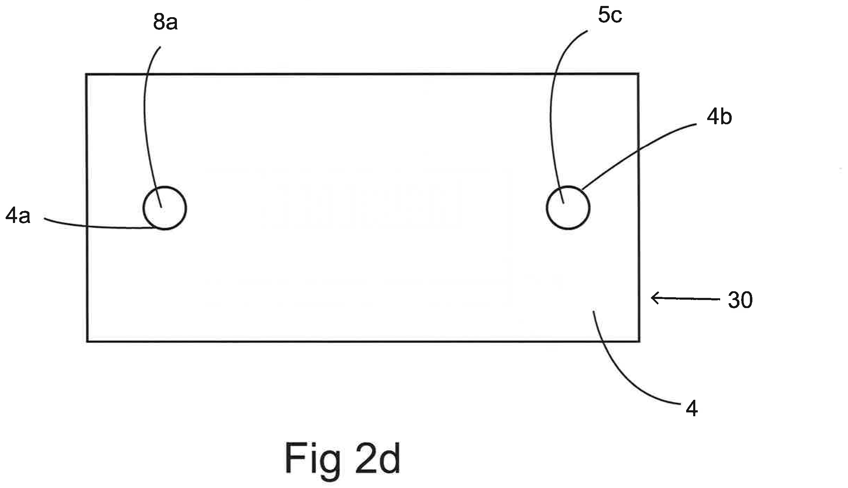

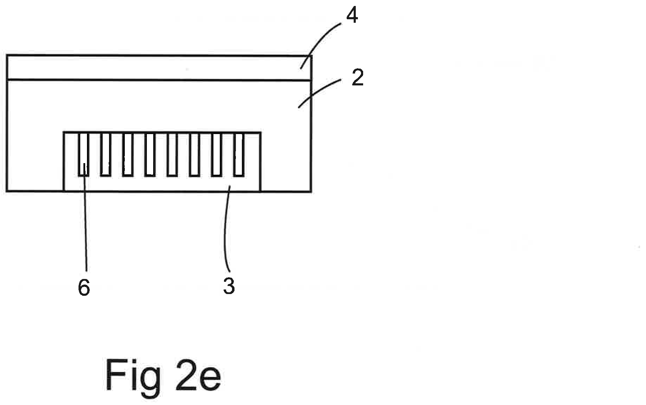

Figure 2a illustrates longitudinal section view of a cooling assembly 1 according to an embodiment of the present invention; Figure 2b shows a top view of a manifold 2 used in the cooling assembly 1; Figure 2c shows a bottom view of the manifold 2; Figure 2d shows a top view of the cooling assembly 1; Figure 2e shows a cross sectional view taken along line A-A' of figure 2a. The cooling assembly 1 can be used as a heat sink in a semiconductor assembly. It should be understood that the cooling assembly 1 may comprise any of the features of any of the other cooling assembly embodiments described in the present application.

Referring to figures 2a-2e, it can be seen the cooling assembly 1 comprises, a manifold 2, and one or more sub-coldplates 3. In this example the cooling assembly 1 has one sub-coldplate 3, however it should be understood that the cooling assembly 1 could have any number of sub coldplates.

The manifold 2 has one or more channels 5 defined therein. Cooling fluid can be selectively flowed along the one or more channels 5 in the manifold 2. In this embodiment the manifold 2 comprises a plurality of fins 7 which define a plurality of parallel channels 5. At one end, each of the plurality of parallel channels 5 is fluidically connected to a single outlet 8b which is defined in the manifold 2; and at a second opposite end each of the plurality of parallel channels 5 is fluidically connected to an end 15 channel-portion 5c (so cooling fluid can flow from the single outlet 8b, along the channels 5, and into the end-channel-portion 5c). The manifold 2 further comprises a single inlet 8a defined therein. It should be understood that the manifold may comprise any suitable material; for example the manfold may comprise any one or more of copper, aluminium, stainless steel, invar, kovar, Hastelloy, Inconel, or polymers. Preferably the manifold will comprise a heat conducting material. Preferably the manifold will comprise a material which has a coefficient of thermal expansion which is within 15 ppm/K of the coefficient of thermal expansion of the material of the sub-coldplates.

The sub-coldplate 3 is attached to the manifold 2. The sub coldplate 3 has one or more channels 6 defined therein along which cooling fluid can flow. In this example the sub-coldplate 3 has a plurality of channels 6 defined therein (as can be best seen in Figure 2e). Each of the respective channels 6 have an inlet 16a which is at one end of the channel 6, and an outlet 16b which is an opposite end of the channel 6

In another embodiment the sub-coldplate 3 may have a single channel (e.g. a single meandering channel). The single channel may have a single inlet which is at one end of the single channel, and a single outlet which is an opposite end of the channel.

Each of the channels 6 in the sub-coldplate 3 are fluidically connected to the inlet 8a and outlet 8b in the manifold 2; specifically the inlet 16a of each channel 6 is fluidically connected to the inlet 8a of the manifold, and the outlet 16b of each channel 6b is fluidically connected to the outlet 8b of the manifold 2. Cooling fluid can flow through the inlet 8a in the manifold 2, into through each of the channels 6 in the sub coldplate 3 and then through the outlet 8b and into the channels 5 in the manifold 2. The fins 7 in the manifold 2 will help to improve heat transfer from the manifold 2 to the cooling fluid which is flowing through the channels 5. In an embodiment one or more pillars and/or fins may be located within the channel 6 in the sub-coldplate 3; these pillars and/or fins will help to improve heat transfer from the sub-coldplate 3 to the cooling fluid.

In a preferred embodiment, the cooling fluid will then flow from the channels 5 in the manifold 2 into an external collection reservoir and/or heat exchanger. So, in an embodiment the cooling assembly 1 may further comprise a reservoir, and/or a heat exchanger, which can receive cooling fluid which is discharged from the channels 5 in the manifold.

The manifold 2 comprises a first surface 2a and a second, opposite, surface 2b. Preferably the channels 5 of the manifold 2 are defined in the first surface 2a of the manifold 2.

The cooling assembly 1 further comprises a cap layer 4 which is attached to the first surface 2a of the manifold 2. The cap layer 4 is preferably attached to the first surface 2a of the manifold 102 such that it creates a leak tight seal between the cap layer 4 and first surface 2a of the manifold 102. The cap layer 4 may be attached to the first surface 2a of the manifold 102 by any suitable attachment means; for example, the cap layer 4 may be attached to the first surface 2a of the manifold 102 by means of gaskets, tape, glue, soldering and/or brazing. When using a gasket or tape, to attach the cap layer 4 then the cap layer 4 may be kept in contact with the first surface 2a of the manifold 102 using screws, springs, or any other suitable fastening means. The cap layer 4 may comprise a polymeric material (such as, for example, any one or more of, PMMA, Polycarbonate, HDPE, PVC, PEEK, Nylon, FR4...) and/or a metal (such as, for example, any one or more of, Aluminium, Stainless steel, Copper, Invar, Kovar, molybdenum, aluminium nitride, aluminium oxide, nickel-iron alloys, nickel-iron-cobalt alloys and aluminium-silicon alloys, Hastelloy or Inconel) and/or silicon. Cap layer 4 . The cap layer 4 has a first opening 4a and a second opening 4b defined therein (as can also be seen in Figure 2d). The first opening 4a is aligned over the inlet 8a of the manifold 2 and the 15 second opening 4b is aligned over the end channel portion 5c of the manifold 2. Cooling fluid can be passed into the inlet 8a via the first opening 4a and cooling fluid can pass from the end channel portion 5c of the manifold 2 into the second opening 4b. Not only can the first and second openings 4a,4b and a second opening 4b serve as an inlet and outlet ports for the cooling fluid, they can also serve as threads, fluidic connectors, fittings, cavities for o-rings or other gaskets, alignment features. One of the functions of the cap layer 4 may be to provide a roof on (i.e. close from above) the the channels 5 defined in the manifold 2; another function may be to create a preferred path for the fluid in the 25 manifold to access only selective parts of the sub-coldplate.

A surface 3a of each the sub-coldplate 3 which is facing away from the manifold 2 is flush with the second surface 2b of the manifold 2. In this embodiment the manifold 2 has a pocket 9 defined therein. The sub coldplate 3 is located in the pocket 9. In this example the depth 'd' of the pocket 9 is equal to the thickness 't' of the sub-coldplate 3 so that the surface 3a of the sub-coldplate 3 which is facing away from the manifold 2 is flush with the second surface 2b of the manifold 2. Advantageously this allows both the second surface 2b of the manifold 2 and the sub-coldplate 3 to be easily arranged to, simultaneously, thermally contact respective semiconductor components. In particular, the sub-coldplate 3 can thermally contact a semiconductor component in a chip assembly which produces a heat flux which is above a predefined threshold heat flux, while the manifold 2 can thermally contact a semiconductor component in the chip assembly which produce a heat flux which is below a predefined threshold heat flux. Accordingly, the cooling assembly is optimized to have the minimum necessary sub-coldplates for use with a particular chip assembly.

Most preferably the area dimensions of the surface 3a of the sub coldplate 3 which is facing away from the manifold 2 may be in the range 1mm*1mm- 250mm*250mm; and is preferably in the range 2mm*2mm 50*50 mm; and it most preferably in the range 5mm*5mm-30mm*30mm. Such dimensions will ensure that the surface 3a of the sub-coldplate 3 matches the dimensions of commonly used semiconductor components.

In a preferred embodiment the sub-coldplate 3 comprises silicon. Typically, the sub-coldplate 3 will be thermally connected to a silicon semiconductor, having the sub-coldplate 3 being of the same material as the semiconductor component which is cooled by the sub-coldplate 3 is advantageous because the mechanical changes that occur in the semiconductor component, due to heat, when in use, will be mirrored by the sub-coldplate 3. It should be understood that the sub-coldplate 3 could comprise any suitable material; for example the sub-coldplate 3 could comprise any one or more of silicon, copper, nickel and/or gold.

In an embodiment of the cooling assembly 1 there is an intermediate layer interposed between the sub-coldplate 3 and the 25 manifold 2. The intermediate layer preferably comprises glass. An adhesive maybe used to attach the sub-coldplate 3 to one surface of the glass layer and an adhesive may be used to attach the manifold 2 to an opposite surface of the glass layer; in a preferred embodiment the sub-coldplate 3 is attached to the glass layer by means of a wafer bond, which can be formed through a process such as anodic bonding, which directly bonds sub coldplate 3 to the glass layer using electricity. Advantageously, the surfaces of the glass layer have low surface roughness thereby allowing for good adhesion to the sub-coldplate 3 and manifold 2; in other words the use of an intermediate glass layer enables the positions of sub-coldplate 3 and manifold 2 to be more securely fixed. It should be understood that the intermediate layer may be composed of any suitable material; for example the intermediate layer may comprise any one or more of glass, silicon, copper, molybdenum, aluminium nitride, aluminium oxide, nickel-iron alloys, nickel-iron-cobalt alloys and aluminium-silicon alloys, Hastelloy or Inconel. It should be understood that the intermediate layer may take any suitable form; for example, the intermediate layer could be a layer of glue, an adhesive tape, a plastic sheet or a metal layer.

The intermediate layer may serve two main functions: firstly, the intermediate layer may provide a cover over the channels 6 in the sub coldplate 3; and secondly, the intermediate layer may provide a selected path for the fluid coming from the manifold to specific sections (e.g. specific channels 6) of the sub-coldplate, thus creating a specific path for the fluid to access selected areas of the sub-coldplate 3. In a preferred embodiment, the intermediate layer is glass, and most preferably is a glass with a Coefficient of Thermal Expansion that is within 15 ppm/K of the Coefficient of Thermal Expansion of the material of the sub-coldplate 3 (e.g. silicon). In this preferred embodiment, the glass intermediate layer is bonded to the sub-coldplate 3 by means of an anodic bonding process.

In an embodiment, the cap layer 4 may comprise a polymeric material (such as, for example, any one or more of, PMMA, Polycarbonate, 25 HDPE, PVC, PEEK, Nylon, FR4...) and/or a metal (such as, for example, any one or more of, Aluminium, Stainless steel, Copper, Invar, Kovar, molybdenum, aluminium nitride, aluminium oxide, nickel-iron alloys, nickel-iron-cobalt alloys and aluminium-silicon alloys, Hastelloy or Inconel) and/or silicon. In one embodiment, in which the cap layer 4 and sub sub 30 coldplate 3 preferably comprise the same material composition, then the cap layer 4 and sub-coldplate 3 may be directly bonded together; for example, if the cap layer 4 comprises silicon and the sub-coldplate 3 also comprises silicon, then the cap layer and sub-coldplate 3 may be directly bonded together using a direct bonding process (i.e. there is no need for an intermediate layer). In another exemplary embodiment a silicon intermediate layer is provided between the cap layer 4 and the sub coldplate 3; the silicon intermediate layer is attached to the cap layer 4 and the sub-coldplate 3 by hybrid bonding. In yet another exemplary embodiment the cap layer 4 and sub-coldplate 3 both comprise silicon, and a silicon intermediate layer is provided between the cap layer 4 and sub coldplate 3 a; the silicon intermediate layer is attached to the silicon cap layer 4 and the silicon sub-coldplate 3 thus allowing face-to-face electrical connection of the bonded wafers.

Preferably, the intermediate layer will comprise a first and second cutout; the first cutout will have dimensions equal to, or substantially equal to, the dimensions of the inlet 8a in the manifold 2 and will be aligned with the inlet 8a so that the intermediate layer does not obstruct the flow of cooling fluid from the inlet 8a in the manifold 2 to the channels 6 in the sub-coldplate 3; and the second cutout will have dimensions equal to, or substantially equal to, the dimensions of the outlet 8b in the manifold 2 and will be aligned with the outlet 8b so that the intermediate layer does not obstruct the flow of cooling fluid from the channels 6 in the sub-coldplate 3 into the outlet 8b in the manifold 2.

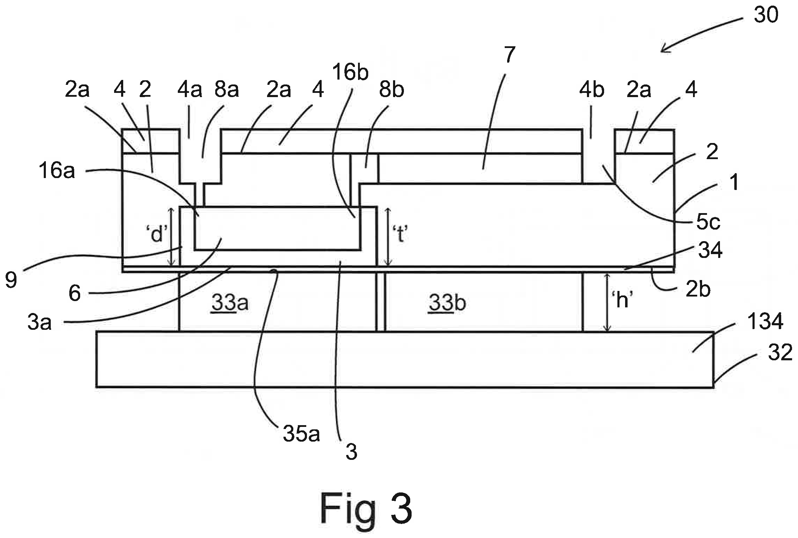

Figure 3 illustrates a longitudinal section view of semiconductor assembly 30 according to a further aspect of the present invention. It should be understood that the semiconductor assembly 30 may comprise any of the features of any of the other semiconductor assembly embodiments described in the present application.

The semiconductor assembly 30 comprises the cooling assembly 1 of Figure 2a and like features are awarded the same reference numbers. The semiconductor assembly 30 further comprises a chip assembly 32 which comprises a PCB 134 and a plurality of semiconductor components 33a,33b mounted on the PCB 134. In this embodiment the semiconductor assembly comprises a first semiconductor component 33a and a second semiconductor component 33b. In this embodiment each of semiconductor components 33a,33b have equal height 'h'. In another embodiment the height 'h' of each of the semiconductor components 33a,33b may not be precisely equal (due to manufacturing tolerances) however the difference between the height of one of the semiconductor components 33a,33b is preferably not more than 150 micrometers.

The first semiconductor component 33a is known to produce a heat flux which is above a predefined threshold heat flux when the chip assembly 32 is in use; the second semiconductor component 33b is known to produce a heat flux which is below the predefined threshold heat flux when the chip assembly 32 is in use.

The cooling assembly 1 is mounted on the chip assembly 32, and the sub-coldplate 3 is aligned with, and thermally connected to, the first semiconductor component 33a, and the manifold 2 is thermally connected to second semiconductor component 33b. More specifically, the sub coldplate 3 is aligned with and thermally connected to, the first semiconductor component 33a which is known to produce a heat flux which is above a predefined threshold heat flux when the chip assembly 32 is in use; the manifold 2 is thermally connected to the second semiconductor component 33b which is known to produce a heat flux which is below the predefined threshold heat flux when the chip assembly 32 is in use. Specifically, in this embodiment, the channels 5 in the manifold 2 are aligned over the second semiconductor component 33b. The dimensions of the surface 3a of the sub-coldplate 3 which is facing away from the manifold 2 is equal to the dimension of a surface 35a of the first semiconductor component 33a which is facing towards the cooling assembly 1.

The semiconductor assembly 34 preferably further comprises a thermal interface material layer 34 which is interposed between the first semiconductor component 33a and the sub-coldplate 6, and is also interposed between the second semiconductor component 33b and the manifold 2. Preferably the thermal interface material layer 34 covers the whole of the second surface 2b of the manifold.

During use cooling fluid is provided into the inlet 8a in the manifold 2 via the first opening 4a of the cap layer 4. The cooling fluid flows through the inlet 8a in the manifold 2 and into the channels 6 in the sub-coldplate 3; the cooling fluid flows along the channels 6 in the sub coldplate absorbing heat from the sub-coldplate 3 which the sub-coldplate 3 has conducted away from the first semiconductor component 33a. Pillars and/or fins that may be located within the channels 6 in the sub-coldplates 3 may help to improve heat transfer from the sub-coldplate 3 to the cooling fluid.

The cooling fluid then flows from each of the channels 6 in the sub-coldplate 3 into the outlet 8b in the manifold 2, and from the outlet 8b into the channels 5 in the manifold 2. As the cooling fluid flows through the channels 5 in the manifold 2 the cooling fluid absorbs heat from the manifold 2 which the manifold 2 has conducted away from the second semiconductor component 33b. The fins 7 in the manifold 2 will help to improve heat transfer from the manifold 2 into the cooling fluid which is flowing through the channels 5. The heated cooling fluid is then preferably dispensed from the channels 5 into a reservoir and/or a heat exchanger.

In other words, heat produced by the first semiconductor component 33a is conducted into the sub-coldplate 3, and that heat is absorbed by the cooling fluid when it flows through the channels 6 in the sub-coldplate 3; heat produced by the second semiconductor component 33b is conducted into the manifold 2 and also into the fins 7 of the manifold 2, and that heat is absorbed by the cooling fluid when it flows through the channels 5 in the manifold 2. The heated cooling fluid is then preferably dispensed from the channels 5 into a reservoir and/or a heat exchanger.

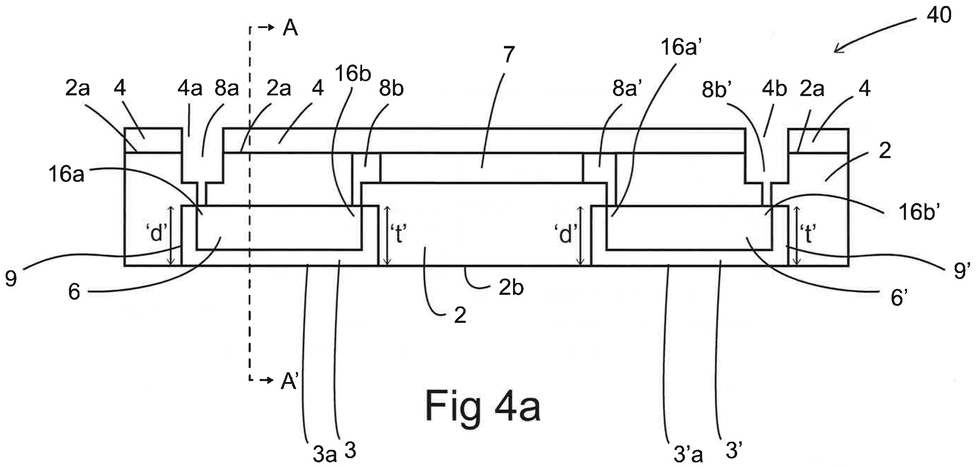

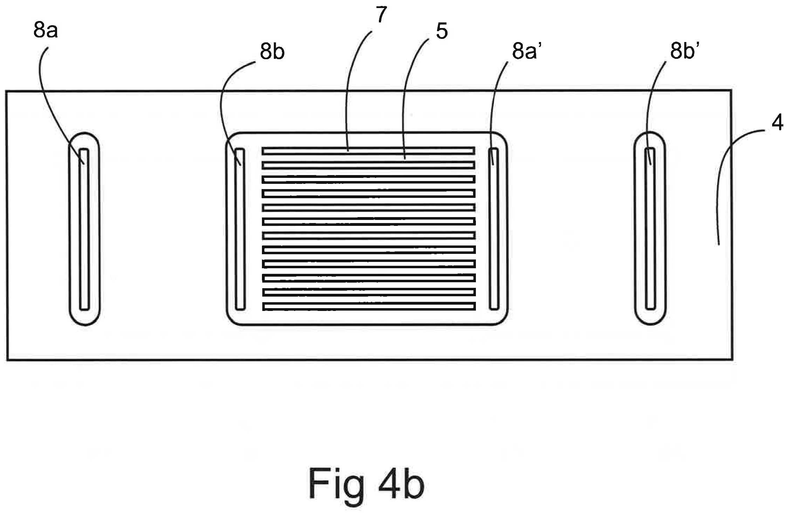

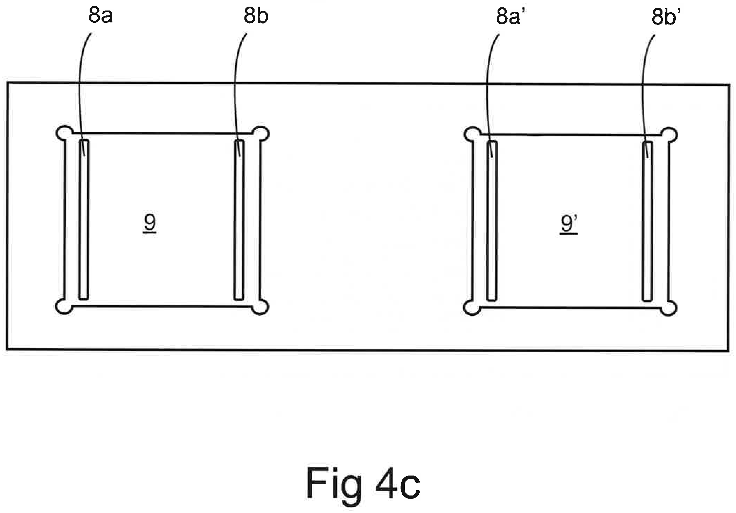

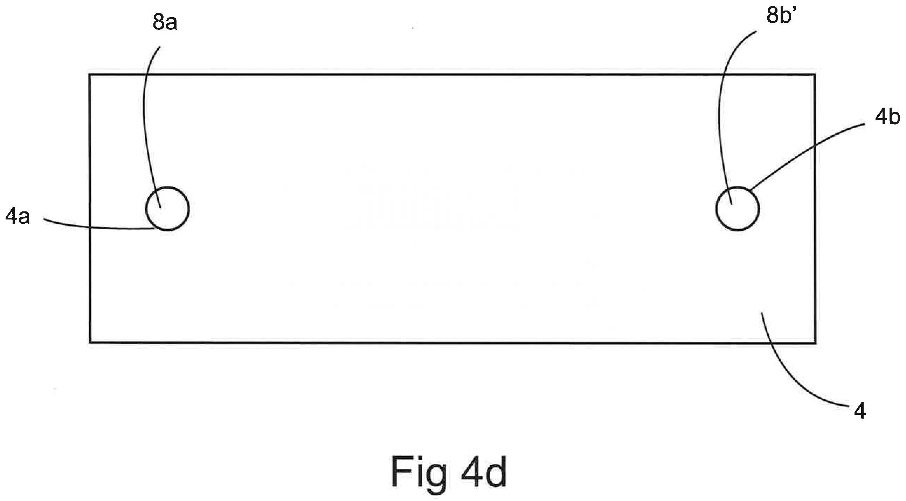

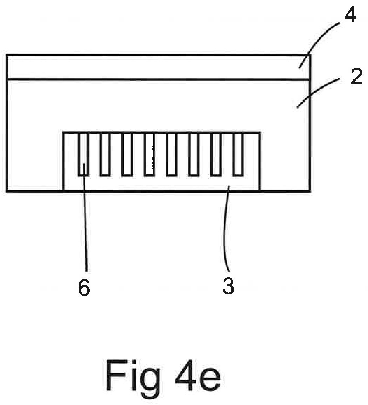

Figure 4a illustrates a longitudinal section view of a cooling assembly 40 according to an embodiment of the present invention; Figure 4b shows a top view of a manifold 2 used in the assembly 40; Figure 4c shows a bottom view of the manifold 2; Figure 4d shows a top view of the cooling assembly 40; Figure 4e shows a cross sectional view taken along line A-A' of figure 4a. The cooling assembly 40 can be used as a heat sink in a semiconductor assembly. It should be understood that the cooling assembly 40 may comprise any of the features of any of the other cooling assembly embodiments described in the present application.

The cooling assembly 40 has many of the same features as the cooling assembly 1 shown in Figure 2a and like features are awarded the same reference numbers.

The cooling assembly 40 further comprises a second sub-coldplate 3' which is attached to the manifold 2. However, it should be understood that the cooling assembly 1 could have any number of sub-coldplates. The second sub-coldplate 3' has one or more channels 6' defined therein along which cooling fluid can flow. In this example second sub-coldplate 3' has a plurality of channels 6'. One or more pillars and/or fins may be located within the channels 6' in the second sub-coldplate 3; these pillars and/or fins will help to improve heat transfer from the second sub-coldplate 3 to the cooling fluid. Each of the channels 6' have a respective inlet 16a' which is at one end of the channel 6', and a respective outlet 16b' which is the opposite end of the channel 6'. In another embodiment the second sub coldplate 3' may have a single channel (e.g. a single meandering channel); 25 the single channel may have a single inlet which is at one end of the single channel, and a single outlet which is an opposite end of the channel 6.

The manifold 2 further comprises a second inlet 8a' and a second outlet 8b' defined therein. Each of the plurality of parallel channels 5 is fluidically connected to the first outlet 8b and the second inlet 8a'. The channel 6' in the second sub-coldplate 3' is fluidically connected to the second inlet 8a and second outlet 8b in the manifold 2; specifically the inlets 16a' of the respective channels 6' in the second sub-coldplate 3' are fluidically connected to the second inlet 8a' of the manifold 2, and the outlets 16b' of the respective channels 6' in the second sub-coldplate 3' is fluidically connected to the second outlet 8b' of the manifold 2.

Cooling fluid can flow through the first inlet 8a in the manifold 2, and into the channels 6 (via the inlet 16a of the channel 6s); the cooling fluid will flow through the channels 6 in the first sub-coldplate 3, and then into the first outlet 8b (via the outlet 16b of the channel 6); the cooling fluid will then flow through the first outlet 8b and into the channels 5 in the manifold 2. The fins 7 in the manifold will help to improve heat transfer from the manifold 2 to the cooling fluid which is flowing through the channels 5 in the manifold 2. The cooling fluid will then flow from the channels 5 in the manifold 2 into the second inlet 8a', and from the second inlet 8a' into the channels 6' in the second sub-coldplate 6' (via the inlet 16a' of the channels 6'), through the channels 6' in the second sub coldplate 3, and then into the second outlet 8b' (via the outlet 16b' of the channels 6'). In an embodiment one or more pillars and/or fins may be located within the channels 6,6' in the first and/or second sub-coldplates 3,3'; these pillars and/or fins will help to improve heat transfer from the 20 first and/or second sub-coldplates 3,3' to the cooling fluid.

In a preferred embodiment, the cooling fluid will then flow from the second outlet 8b' into an external collection reservoir and/or a heat exchanger. So in an embodiment the cooling assembly 1 may further comprise a reservoir, and/or a heat exchanger, which can receive cooling fluid which is discharged from the second outlet 8b'.

A surface 3a' of the second sub-coldplate 3' which is facing away from the manifold 2 is also flush with the second surface 2b of the manifold 2. In this embodiment the manifold 2 has a second pocket 9' defined therein. It should be understood that the manifold 2 may have any number of pockets defined therein; preferably the number of pockets defined in the manifold 2 will be equal to the number of sub-coldplates so that each sub-coldplate can be located into a respective pocket. The second sub-coldplate 3' is located in the second pocket 9'. In this example the depth 'd' of the second pocket 9' is equal to the thickness 't' of the second sub-coldplate 3' so that the surface 3a' of the second sub-coldplate 3' which
5 is facing away from the manifold 2 is flush with the second surface 2b of the manifold 2. Since both the surface 3a of the first sub-coldplate 3 and the surface 3a' of the second sub-coldplate are both flush with the second surface 2b of the manifold 2, advantageously this allows the second surface 2b of the manifold 2 and the first and second sub-coldplates 3, 3' to be easily arranged to, simultaneously, thermally contact respective semiconductor components. In particular, the first sub-coldplate 3 can thermally contact a first semiconductor component in a chip assembly which produces a heat flux which is above a predefined threshold heat flux, while the manifold 2 thermally contacts a second semiconductor component in the chip assembly which produces a heat flux which is below a predefined threshold heat flux, and the second sub-coldplate 3' thermally contacts a third semiconductor component in a chip assembly which produces a heat flux which is above a predefined threshold heat flux. Accordingly, the cooling assembly is optimized to have the minimum necessary sub-coldplates for use with a particular chip assembly.

Most preferably the area dimensions of the surface 3a' of the second sub-coldplate 3' which is facing away from the manifold 2 may be in the range 1mm*1mm- 250mm*250mm; and is preferably in the range 2mm*2mm-50*50 mm; and it most preferably in the range 5mm*5mm 30mm*30mm. Such dimensions will ensure that the surface 3a' of the second sub-coldplate 3' matches the dimensions of commonly used semiconductor components.

In a preferred embodiment the second sub-coldplate 3' comprises silicon. Typically, the second sub-coldplate 3' will be thermally connected to a silicon semiconductor component; having the second sub-coldplate 3' being of the same material as the semiconductor component which is cooled by the second sub-coldplate 3' is advantageous because the mechanical changes that occur, due to heat, in the semiconductor component, when in use, will be mirrored by the second sub-coldplate 3'. It should be understood that the second sub-coldplate 3' could comprise any suitable material; for example the second sub-coldplate 3' could comprise any one or more of silicon, copper, nickel and/or gold.

The cap layer 4 in the cooling assembly 40 has a first opening 4a and a second opening 4b defined therein (as can also be seen in Figure 4d). The first opening 4a is aligned over the first inlet 8a of the manifold 2 and the second opening 4b is aligned over the second outlet 8b' of the manifold 2. Cooling fluid can be passed into the first inlet 8a through the first opening 4a and cooling fluid can pass from the second outlet 8b into the second opening 4b.

During use, cooling fluid is provided, via the first opening 4a in the cap layer 4, into the first inlet 8a in the manifold 2. The cooling fluid will flow through the first inlet 8a in the manifold 2, through the channels 6 in the first sub-coldplate 3, and then through the first outlet 8b and into the channels 5 in the manifold 2. The cooling fluid will flow through the channels 5 in the manifold and the fins 7 in the manifold will help to improve heat transfer from the manifold 2 to the cooling fluid which is flowing through the channels 5 in the manifold 2. The cooling fluid will then flow from the channels 5 in the manifold 2 into the second inlet 8a', and from the second inlet 8a' into the channels 6' in the second sub coldplate 3', and then flow through the second outlet 8b'. The cooling fluid may then flow from the second outlet 8b' in the manifold 2, through second opening 4b in the cap 4, and into a collection reservoir and/or a 25 heat exchanger.

In an embodiment the cooling assembly 40 may further comprise an intermediate layer which is interposed between the first and second sub-coldplates 3,3' and the manifold 2. The intermediate layer preferably comprises glass. The intermediate layer may comprise any of the features of the intermediate layer described for the cooling assembly 1 and/or any variations described in the present application. An adhesive maybe used to attach the first and second sub-coldplates 3,3' to one surface of the glass layer and an adhesive may be used to attach the manifold 2 to an opposite surface of the glass layer; in a preferred embodiment the first and second sub-coldplates 3,3' are each attached to the glass layer by means of a wafer bond, which can be formed through a process such as anodic bonding, which directly bonds the first and second sub-coldplates 3,3' to the glass layer using electricity. Advantageously, the surfaces of the glass layer have low surface roughness thereby allowing for good adhesion to the sub coldplates 3,3' and manifold 2; in other words the use of an intermediate glass layer enables the positions of sub-coldplates 3,3' and manifold 2 to be more securely fixed. It should be understood that the intermediate layer may be composed of any suitable material; for example the intermediate layer may comprise any one or more of glass, silicon, copper, molybdenum, aluminium nitride, aluminium oxide, nickel-iron alloys, nickel-iron-cobalt alloys and aluminium-silicon alloys, Hastelloy or Inconel.

The intermediate layer will preferably comprise a first, second, third and fourth cutout; the first cutout will have dimensions equal to, or substantially equal to, the dimensions of the first inlet 8a and will be aligned with the first inlet 8a so that the intermediate layer does not obstruct the flow of cooling fluid from the first inlet 8a in the manifold 2 to the channels 6 in the first sub-coldplate 3; the second cutout will have dimensions equal to, or substantially equal to, the dimensions of the first outlet 8b and will be aligned with the first outlet 8b so that the intermediate layer does not obstruct the flow of cooling fluid from the channels 6 in the first sub-coldplate 3 into the first outlet 8b in the manifold 2; the third cutout will have dimensions equal to, or substantially equal to, the dimensions of the second inlet 8a' and will be aligned with the second inlet 8a' so that the intermediate layer does not obstruct the flow of cooling fluid from the second inlet 8a' in the manifold 2 to the channels 6 in the second sub-coldplate 3'; and the fourth cutout will have dimensions equal to, or substantially equal to, the dimensions of the second outlet 8b' and will be aligned with the second outlet 8b so that the intermediate layer does not obstruct the flow of cooling fluid from the channels 6 in the second sub-coldplate 3' into the second outlet 8b in the manifold 2.

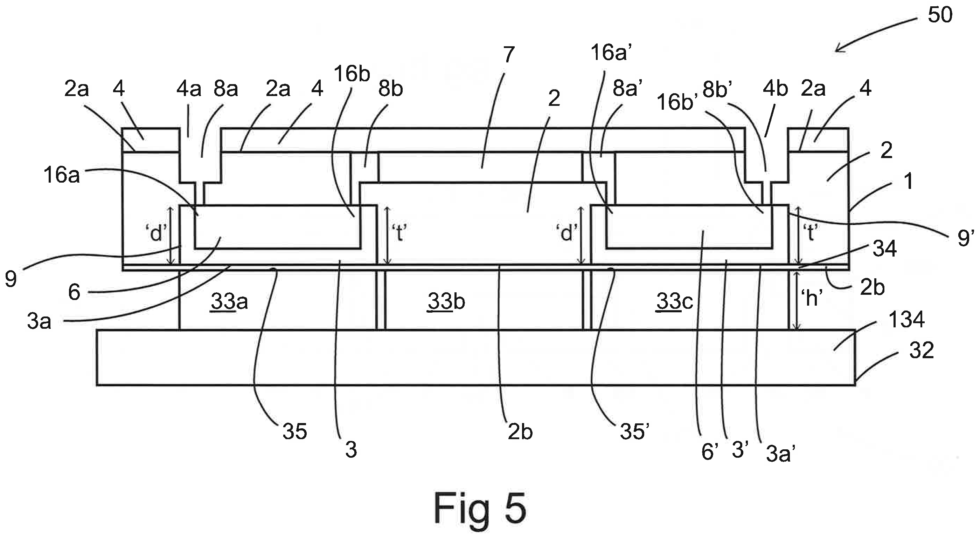

Figure 5 illustrates a longitudinal section view of semiconductor assembly 50 according to an embodiment of the present invention. It should be understood that the semiconductor assembly 50 may comprise any of the features of any of the other semiconductor assembly embodiments described in the present application.

The semiconductor assembly 50 comprises the cooling assembly 40 of Figure 4a and like features are awarded the same reference numbers. The semiconductor assembly 50 further comprises a chip assembly 52 which comprises a PCB 134 and a plurality of semiconductor components 33a,33b,33c. In this embodiment the chip assembly 52 comprises, a first semiconductor component 33a which is known to produce a heat flux which is above a predefined threshold heat flux when the chip assembly 52 15 is in use; a second semiconductor component 33b which is known to produce a heat flux which is below the predefined threshold heat flux when the chip assembly 52 is in use; and a third semiconductor component 33c which is known to produce a heat flux which is above a predefined threshold heat flux when the chip assembly 52 is in use.

In this embodiment each of semiconductor components 33a,33b,33c have equal height 'h'. In another embodiment the height 'h' of each of the semiconductor components 33a,33b,33c may not be precisely equal (due to manufacturing tolerances for example) however the difference between the height of one of the semiconductor components 33a,33b,33c and any of the other semiconductor components 33a,33b,33c is preferably not more than 150 micrometers.

The cooling assembly 40 is mounted on the chip assembly 52, and the first sub-coldplate 3 is aligned with, and thermally connected to, a first semiconductor component 33a; the manifold 2 is thermally connected to second semiconductor component 33b; and the second sub-coldplate 3' is aligned with, and thermally connected to, a third semiconductor component 33c. More specifically, the first sub-coldplate 3 is aligned with and thermally connected to, the first semiconductor component 33a which is known to produce a heat flux which is above a predefined threshold heat flux when the chip assembly 52 is in use; the manifold 2 is thermally connected to the second semiconductor component 33b which is known to produce a heat flux which is below the predefined threshold heat flux when the chip assembly 52 is in use; the second sub-coldplate 3' is aligned with and thermally connected to, the third semiconductor component 33c 10 which is known to produce a heat flux which is above a predefined threshold heat flux when the chip assembly 52 is in use. Specifically, in this embodiment, the channels 5 in the manifold 2 are aligned over the second semiconductor component 33b. The dimensions of the surface 3a of the first sub-coldplate 3 which is facing away from the manifold 2 is equal to the dimension of a surface 35 of the first semiconductor component 33a which is facing towards the cooling assembly 40; and the dimensions of the surface 3a' of the second sub-coldplate 3' which is facing away from the manifold 2 is equal to the dimension of a surface 35' of the third semiconductor component 33c which is facing towards the cooling assembly 40.

The semiconductor assembly 50 preferably further comprises a thermal interface material layer 34 which is interposed between the first and third semiconductor components 33a,33c and the respective first and second sub-coldplates 3,3' and is also interposed between the second semiconductor component 33b and the manifold 2. Preferably the thermal interface material layer 34 covers the whole of the second surface 2b of the manifold.

During use cooling fluid is provided into the first inlet 8a in the manifold 2, via the first opening 4a in the cap layer 4. The cooling fluid flows through the first inlet 8a in the manifold 2 and into the channels 6 in the first sub-coldplate 3; the cooling fluid flows along the channels 6 in the first sub-coldplate absorbing heat from the first sub-coldplate 3 which the first sub-coldplate 3 has conducted away from the first semiconductor component 33a. Pillars and/or fins that may be located within the channels 6 in the first sub-coldplate 3 to help to improve heat transfer from the first sub-coldplate 3 to the cooling fluid.

The cooling fluid then flows from the channels 6 in the first sub 5 coldplate 3 into the first outlet 8b in the manifold 2, and from the first outlet 8b into the channels 5 in the manifold 2. As the cooling fluid flows through the channels 5 in the manifold 2 the cooling fluid absorbs heat from the manifold 2 which the manifold 2 has conducted away from the second semiconductor component 33b. The fins 7 in the manifold 2 will help to improve heat transfer from the manifold 2 into the cooling fluid which is flowing through the channels 5.

The cooling fluid the flows from the channels 5 in the manifold 2 into the second inlet 8a', and from the second inlet 8a' into the channels 6' in the second sub-coldplate 3'; the cooling fluid flows along the channels 6' in the second sub-coldplate absorbing heat from the second sub-coldplate 3' which the second sub-coldplate 3 has conducted away from the third semiconductor component 33c. Pillars and/or fins that may be located within the channels 6' in the second sub-coldplate 3' to help to improve heat transfer from the second sub-coldplate 3' to the cooling fluid. The cooling fluid will then flow from the channels 6' in the second sub coldplate 3' into the second outlet 8b'. The heated cooling fluid may then be dispensed from the second outlet 8b' via the second opening 4b in the cap layer, into a collection reservoir and/or a heat exchanger.

In other words heat produced by the first semiconductor 25 component 33a is conducted into the first sub-coldplate 3, and that heat is absorbed by the cooling fluid when it flows through the channels 6 in the first sub-coldplate 3; heat produced by the second semiconductor component 33b is conducted into the manifold 2 and also into the fins 7 of the manifold 2, and that heat is absorbed by the cooling fluid when it flows through the channels 5 in the manifold 2; heat produced by the third semiconductor component 33c is conducted into the second sub-coldplate 3', and that heat is absorbed by the cooling fluid when it flows through the channels 6' in the second sub-coldplate 3 '. The heated cooling fluid is then preferably dispensed from the channels 5 into a reservoir and/or a heat exchanger.

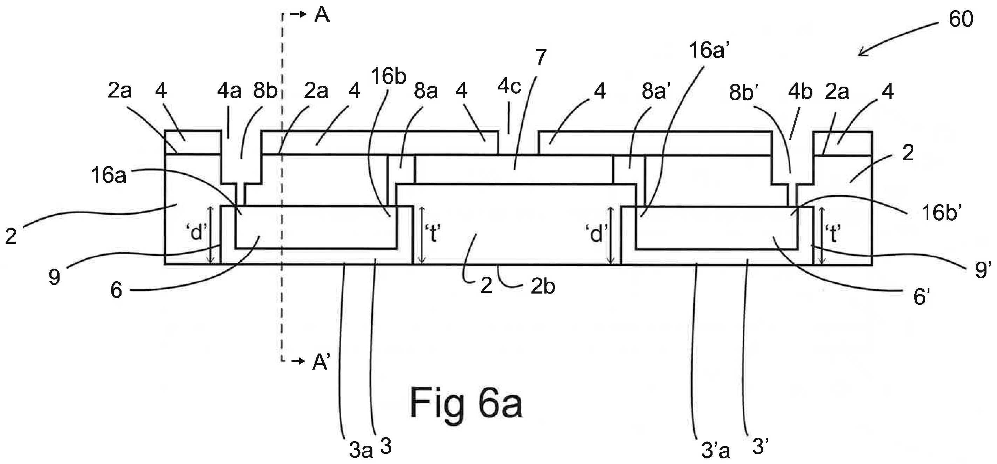

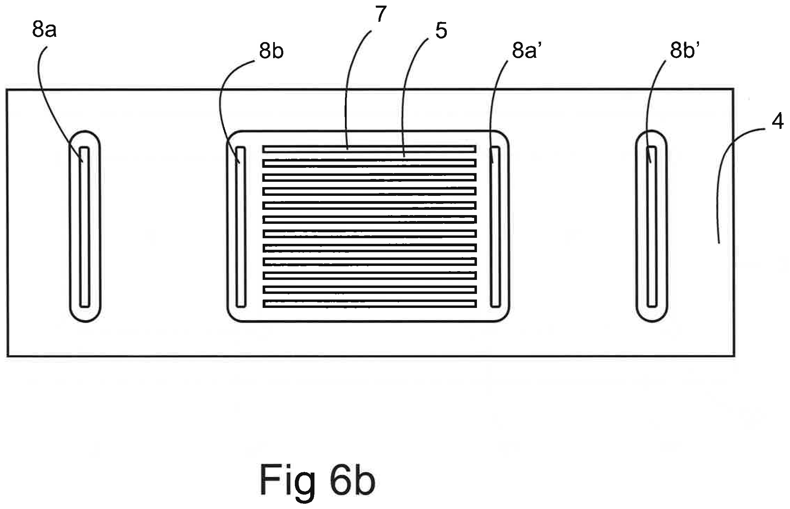

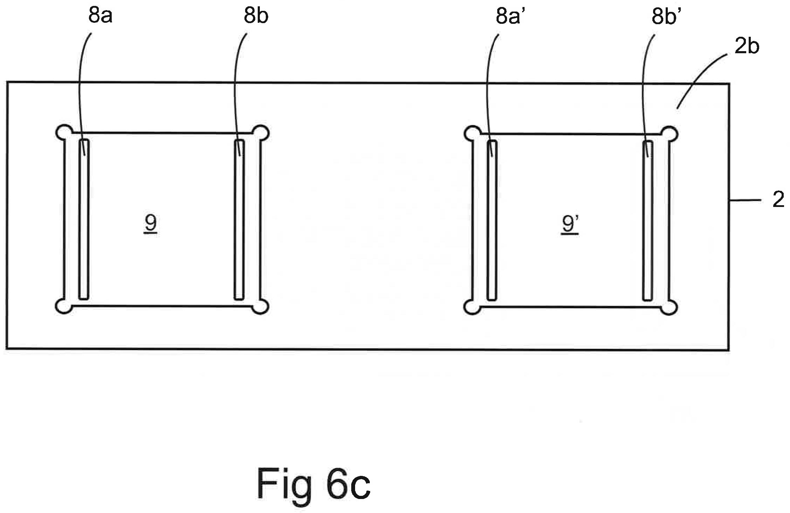

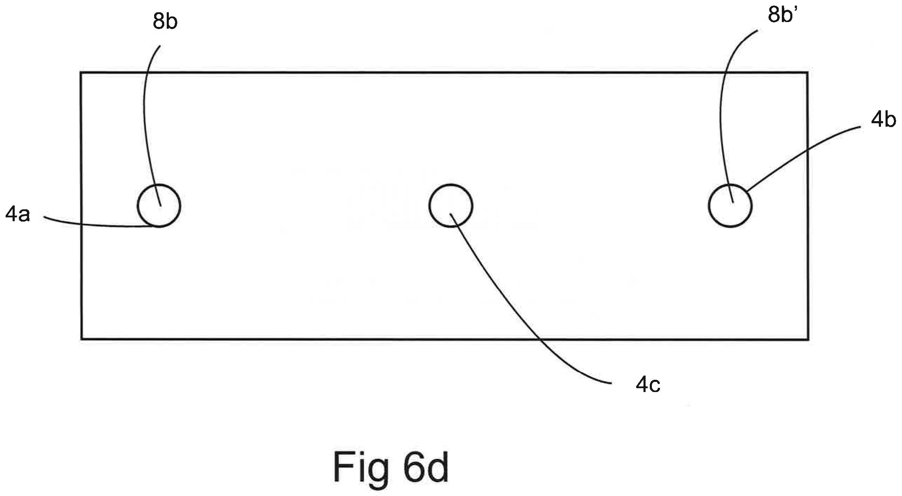

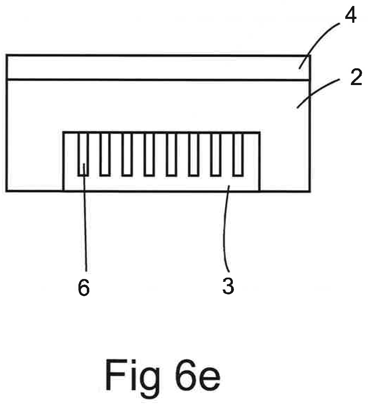

Figure 6a illustrates a longitudinal section view of a cooling assembly 60 according to an embodiment of the present invention; Figure 6b shows a top view of a manifold used in the cooling assembly 60; Figure 6c shows a bottom view of the manifold; Figure 6d shows a top view of the cooling assembly 60; Figure 6e shows a cross sectional view taken along line A-A' of figure 6a. The cooling assembly 60 can be used as a heat sink in a semiconductor assembly. It should be understood that the cooling assembly 60 may comprise any of the features of any of the other cooling assembly embodiments described in the present application.

The cooling assembly 60 has many of the same features as the cooling assembly 40 shown in Figures 4a-d and like features are awarded the same reference numbers.

In the cooling assembly 60 the cap layer 4 has a first opening 4a and a second opening 4b and also a third opening 4c defined therein (as can also be seen in Figure 6d). The first opening 4a is aligned over the first inlet 8a of the manifold 2; the second opening 4b is aligned over the second outlet 8b' of the manifold 2; the third opening 4c is aligned over the cooling channels 5 in the manifold 2. Most preferably the third opening 4c is aligned over a center point of the cooling channel 5 in manifold 2.

In the cooling assembly 60 the locations of the first inlet 8a and first output 8b in the manifold 2 are different than in the cooling assembly 40. Specifically, the first input 8a in the manifold 2 is fluidically connected to the channels 5 in the manifold 2; the first input 8a in the manifold 2 is located between the channels 5 in the manifold 2 and the channels 6 in the first sub-coldplate 3. The first output 8b in the manifold 2 is fluidically connected to the channels 6 in the first sub-coldplate 3 and the first opening 4a in the cap layer 4; the first output 8b in the manifold 2 is located between the channels 6 in the first sub-coldplate 3 and the first opening 4a in the cap layer 4.

Each of channels 5 in the manifold 2 is fluidically connected to both the first inlet 8a and the second inlet 8a' in the manifold 2. The channel 6 in the first sub-coldplate 3 is fluidically connected to the first inlet 8a; and the channels 6' in the second sub-coldplate 3' are fluidically connected to the second inlet 8a' in the manifold 2. The channels 6 in the first sub-coldplate 3 are further fluidically connected to the first outlet 8b in the manifold 2; while the channels 6' in the second sub-coldplate 3' are further fluidically connected to the second outlet 8b' in the manifold 2

The cooling assembly 60 is designed to allow the cooling fluid to follow a different flow path to the flow path which the cooling fluid follows in the assembly 40. During use, cooling fluid is provided via the third opening 4c in the cap layer 4 into the cooling channels 5 in the manifold 2. Some of the cooling fluid will flow in the direction of the first inlet 8a of the manifold 2 and some of the cooling fluid will flow in the direction of the second inlet 8a' of the manifold 2; preferably, roughly half of the cooling fluid provided will flow in the direction of the first inlet 8a of the manifold 2 and the other half of the cooling fluid will flow in the direction of the second inlet 8a' of the manifold 2. The portion of the cooling fluid which flowed in the direction of the first inlet 8a of the manifold 2 will flow through the first inlet 8a, and then into the channels 6 in the first sub-coldplate 3, and then into the first outlet 8b in the manifold; the cooling fluid may then flow from the first outlet 8b through first opening 4a and into a collection reservoir and/or a heat exchanger. The portion of the cooling fluid which flowed in the direction of the second inlet 8a' of the manifold 2 will flow through the second inlet 8a', and then into the channels 6' in the second sub-coldplate 3', and then into the second outlet 8b'; the cooling fluid may then flow from the second outlet 8b through the second opening 4b and into a collection reservoir.

In the cooling assembly 60 the first sub-coldplate 3 and the second sub-coldplate 3' are in parallel along the flow path of the cooling fluid. Consequently some (e.g. half) of the provided cooling fluid flows through the first sub-coldplate 3 and some (the other half) of the provided cooling fluid flows through the second sub-coldplate 3'. By having some (e.g. half) of the provided cooling fluid flow through the first sub-coldplate 3 and some (the other half) of the provided cooling fluid flow through the second sub-coldplate 3', the same mass flow rate can pass through the cooling assembly 60 with a lower pressure drop, since the cooling fluid will
10 only face the flow resistance of a single sub-coldplate (i.e. only one of the first sub-coldplate 3 or the second sub-coldplate 3') (compared to the higher flow resistance the cooling fluid would face if first sub-coldplate 3 or the second sub-coldplate 3' were in series along the flow path of the cooling fluid). Furthermore, improved cooling may be achieved in the cooling assembly 60 compared to if first sub-coldplate 3 or the second sub coldplate 3' were in series along the flow path of the cooling fluid; if the first sub-coldplate 3 or the second sub-coldplate 3' were in series along the flow path the cooling fluid would be heated as is flows through the first sub-coldplate 3 and would enter the channels 6' of the second sub coldplate 3' in an already heated state, and consequently would be less effective at absorbing the heat from the second sub-coldplate 3'; in contrast, in the assembly 60 the portion of the provided cooling fluid that flows into channels 6' of the second sub-coldplate 3', will not have been heated and thus will be more effective at absorbing heat from the the 25 second sub-coldplate 3'.

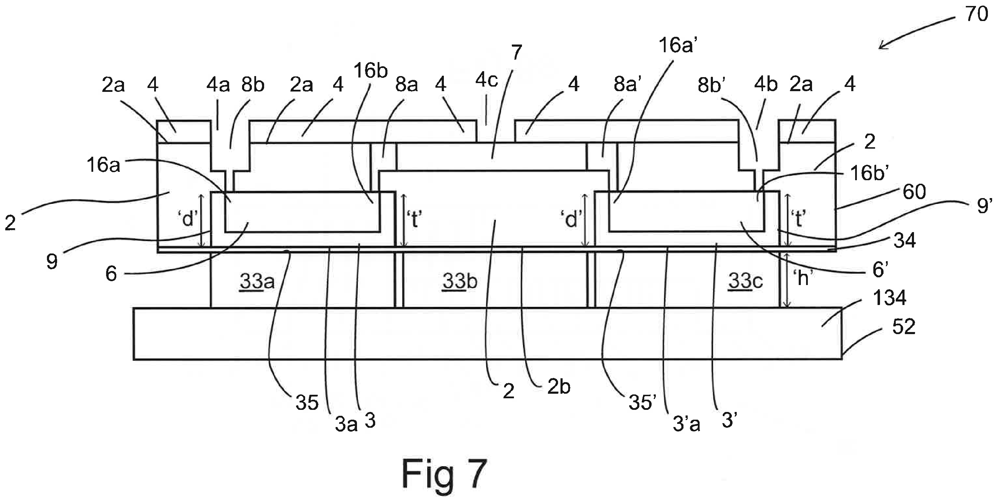

Figure 7 illustrates a longitudinal section view of semiconductor assembly 70 according to an embodiment of the present invention. It should be understood that the semiconductor assembly 70 may comprise any of the features of any of the other semiconductor assembly embodiments described in the present application.

The semiconductor assembly 70 comprises the cooling assembly 60 of Figure 6a and like features are awarded the same reference numbers. The semiconductor assembly 70 further comprises a chip assembly 52 which comprises a PCB 134 and a plurality of semiconductor components 33a,33b,33c. In this embodiment the chip assembly 52 comprises, a first semiconductor component 33a which is known to produce a heat flux which is above a predefined threshold heat flux when the chip assembly 52 is in use; a second semiconductor component 33b which is known to produce a heat flux which is below the predefined threshold heat flux when the chip assembly 52 is in use; and a third semiconductor component 33c which is known to produce a heat flux which is above a predefined threshold heat flux when the chip assembly 52 is in use.

In this embodiment each of semiconductor components 33a,33b,33c have equal height 'h'. In another embodiment the height 'h' of each of the semiconductor components 33a,33b,33c may not be precisely equal (due to manufacturing tolerances for example) however the difference between the height of one of the semiconductor components 33a, 33b, 33c and any of the other semiconductor components 33a,33b,33c is preferably not more than 150 micrometers.

The cooling assembly 60 is mounted on the chip assembly 52, and the first sub-coldplate 3 is aligned with, and thermally connected to a first semiconductor component 33a, the manifold 2 is thermally connected to second semiconductor component 33b, and the second sub-coldplate 3' is aligned with, and thermally connected to a third semiconductor component 33c. More specifically, the first sub-coldplate 3 is aligned with and thermally connected to, the first semiconductor component 33a which is known to produce a heat flux which is above a predefined threshold heat flux when the chip assembly 52 is in use; the manifold 2 is thermally connected to the second semiconductor component 33b which is known to produce a heat flux which is below the predefined threshold heat flux when the chip assembly 52 is in use; and the second sub-coldplate 3' is aligned with and thermally connected to, the third semiconductor component 33c which is known to produce a heat flux which is above a predefined threshold heat flux when the chip assembly 52 is in use.

In this embodiment, the channels 5 in the manifold 2 are aligned over the second semiconductor component 33b.

The channels 5 in the manifold 2 are aligned over the second semiconductor component 33b. The dimensions of the surface 3a of the first sub-coldplate 3 which is facing away from the manifold 2 is equal to the dimension of a surface 35 of the first semiconductor component 33a which is facing towards the cooling assembly 60; and the dimensions of the surface 3a' of the second sub-coldplate 3' which is facing away from the manifold 2 is equal to the dimension of a surface 35' of the third semiconductor component 33c which is facing towards the cooling assembly 60.

During use cooling fluid is provided via the third opening 4c in the cap layer 4 into the cooling channels 5 in the manifold 2. Some of the cooling fluid will flow along the channels 5 in the direction of the first inlet 8a of the manifold 2 and some of the cooling fluid will flow along the channels 5 in the direction of the second inlet 8a' of the manifold 2; preferably, roughly half of the cooling fluid provided will flow along the channels 5 in the direction of the first inlet 8a of the manifold 2 and the other half of the cooling fluid will flow along the channels 5 in the direction of the second inlet 8a' of the manifold 2. As the cooling fluid flows through the channels 5 in the manifold 2 the cooling fluid absorbs heat from the manifold 2 which the manifold 2 has conducted away from the second semiconductor component 33b. The fins 7 in the manifold 2 will help to improve heat transfer from the manifold 2 into the cooling fluid 25 which is flowing through the channels 5.

The portion of the cooling fluid which flowed in the direction of the first inlet 8a, and the portion of the cooling fluid which flowed in the direction of the second inlet 8a' of the manifold 2, will preferably flow simultaneously. The portion of the cooling fluid which flowed in the direction of the first inlet 8a of the manifold 2 will flow through the first inlet 8a, and then into and along the channels 6 in the first sub-coldplate 3. As the cooling fluid flows along the channels 6 in the first sub-coldplate 3 the cooling fluid will absorb heat from the first sub-coldplate 3 which the first sub-coldplate 3 has conducted away from the first semiconductor component 33a. Pillars and/or fins that may be located within the channels 6 in the first sub-coldplate 3 which help to improve heat transfer from the first sub-coldplate 3 into the cooling fluid. The cooling fluid may then flow from the first outlet 8b in the manifold 2, through first opening 4a in the cap layer 4, and into a collection reservoir and/or a heat exchanger.

The portion of the cooling fluid which flowed in the direction of the second inlet 8a' of the manifold 2 will flow through the second inlet 8a', and then into and along the channels 6' in the second sub-coldplate 3'. As the cooling fluid flows along the channels 6' in the second sub-coldplate 3' the cooling fluid will absorb heat from the second sub-coldplate 3' which the second sub-coldplate 3 has conducted away from the third 15 semiconductor component 33c. Pillars and/or fins that may be located within the channels 6 in the second sub-coldplate 3' which help to improve heat transfer from the second sub-coldplate 3' into the cooling fluid. The cooling fluid may then flow from the second outlet 8b' in the manifold 2, through second opening 4b in the cap 4, and into a collection reservoir 20 and/or a heat exchanger.

In other words heat produced by the second semiconductor component 33b is conducted into the manifold 2 and also into the fins 7 of the manifold 2, and that heat is absorbed by the cooling fluid when it flows through the channels 5 in the manifold 2; heat produced by the first semiconductor component 33a is conducted into the first sub-coldplate 3, and that heat is absorbed by the portion of cooling fluid which flows through the channels 6 in the first sub-coldplate 3; heat produced by the third semiconductor component 33b is conducted into the second sub coldplate 3, and that heat is absorbed by the portion of cooling fluid which flows through the channels 6' in the second sub-coldplate 3'. The heated cooling fluid is then preferably dispensed from into a collection reservoir and/or a heat exchanger.

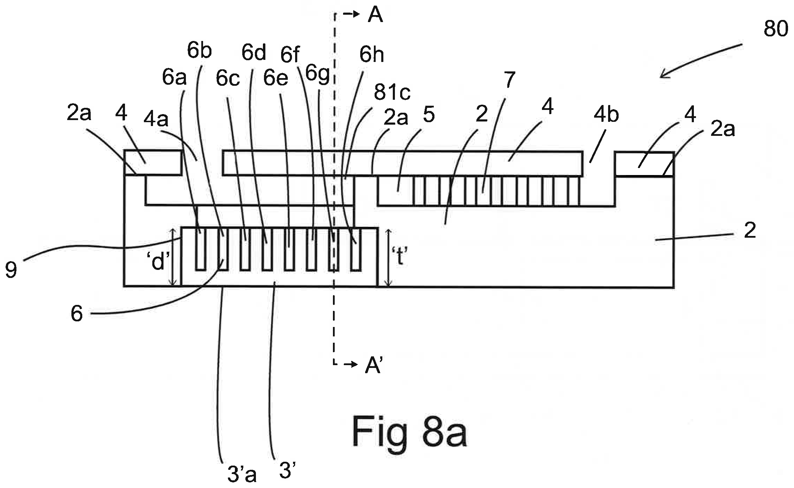

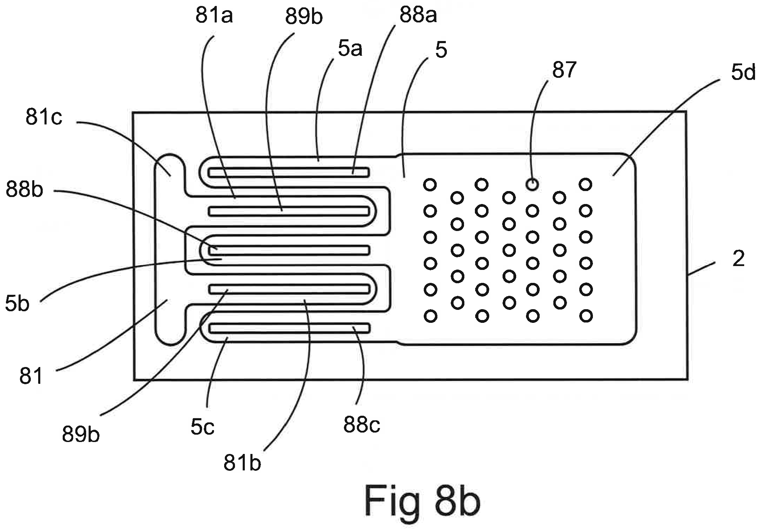

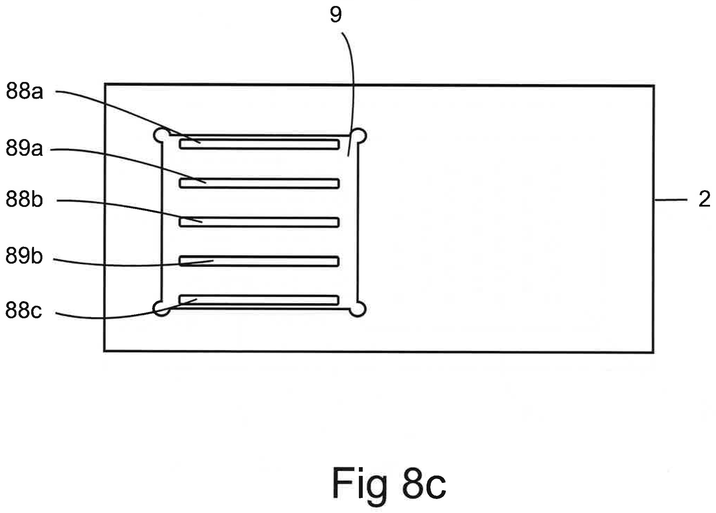

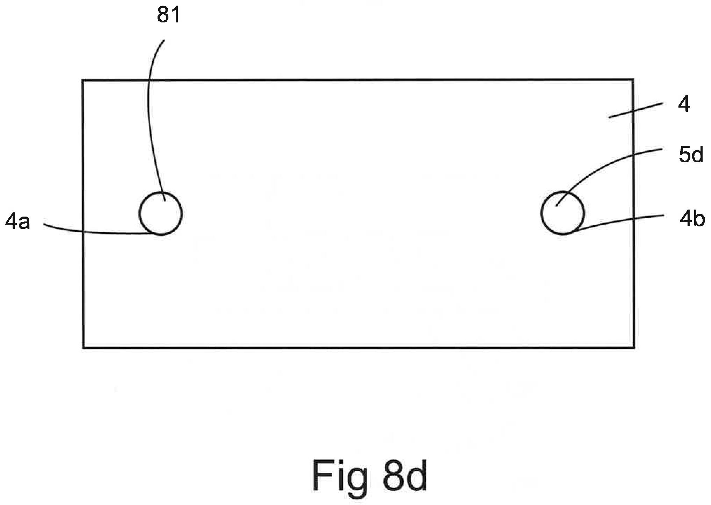

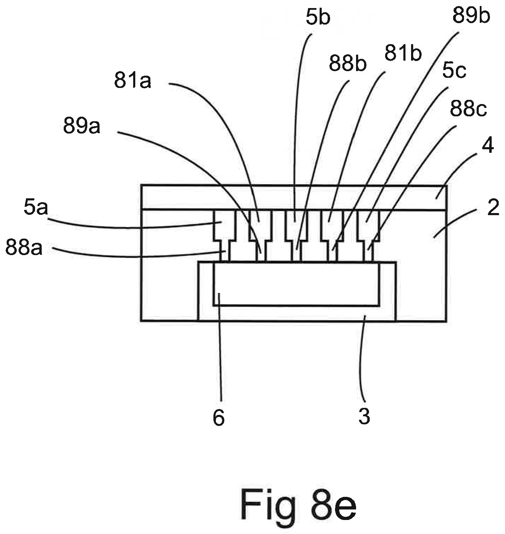

Figure 8a illustrates a longitudinal section view of a cooling assembly 80 according to an embodiment of the present invention; Figure 8b shows a top view a manifold 2 used in the cooling assembly 80; Figure 8c shows a bottom view of the manifold 2; Figure 8d shows a top view of the cooling assembly 80; Figure 8e shows a cross sectional view taken along line A-A' of figure 8a. The cooling assembly 80 can be used as a heat sink in a semiconductor assembly. It should be understood that the cooling assembly 80 may comprise any of the features of any of the other cooling assembly embodiments described in the present application.

The cooling assembly 80 has many of the same features as the cooling assembly 1 shown in Figure 2a and like features are awarded the same reference numbers.

The manifold 2 has an output channel 5 defined therein; the output channel 5 comprises a plurality of subsidiary output channels 5a-5c 15 and a main-output-channel 5d which is fluidically connected to each of the subsidiary output channels 5a-c. In this example the manifold 2 comprises three subsidiary output channels 5a-5c, however it should be understood that the manifold 2 could comprise any number of subsidiary output channels. A plurality of pillars 87 are located in the main-output-channel 5d.

The manifold 2 further comprises a plurality of outlets 88a-88c defined therein; each of the subsidiary output channels 5a-5c is fluidically connected to a respective outlet 88a-88c. In this example the manifold 2 comprises three outlets 88a-88c defined therein, however it should be understood that the manifold 2 could comprise any number of outlets defined therein.

The manifold 2 further comprises an input channel 81 defined therein; the input channel 81 comprises a plurality of subsidiary input channels 81a,81b and a main-input-channel 81c which is fluidically connected to each of the subsidiary input channels 81a,81b. In this example the manifold 2 comprises two subsidiary input channels 81a,81b, however it should be understood that the manifold 2 could comprise any number of subsidiary input channels.

The manifold 2 further comprises a plurality of inlets 89a,89b defined therein; each of the subsidiary input channels 81a,81b is fluidically connected to a respective inlet 89a,89b. In this example the manifold 2 comprises two inlets 89a,89b defined therein, however it should be understood that the manifold 2 could comprise any number of inlets defined therein.

The sub-coldplate 3 has one or more channels 6 defined therein along which cooling fluid can flow. In this example (as was the case for the other cooling assembly embodiments described above) the sub-coldplate 3 has a plurality of channels 6a-6h defined therein; specifically, in this example the sub-coldplate 3 has eight channels 6a-6h defined therein. Each of the channels 6a-6h in the sub-coldplate 3 is fluidically connected to at least some, and preferably all of the inlets 89a,89b; also, each of the channels 6a-6h in the sub-coldplate 3 is fluidically connected to all of the outlets 88a-88c in the manifold 2. In other words all of the channels 6a-6h are fluidically connected to both inlets 89a,89b in the manifold 2; and all of the channels 6a-6h are fluidically connected to all three outlets 88a-88c in the manifold 2.

The cooling assembly 80 further comprises a cap layer 4 which is attached to the first surface 2a of the manifold 2; the cap layer may comprise two or more ports to serve as an inlet and outlet for cooling fluid, threads, fluidic connectors, fittings, cavities for o-rings or other gaskets, alignment features. The cap layer 4 can be attached to the first surface 2a of the manifold 102 such that it creates a leak tight seal using gaskets, tape, glue, soldering or brazing. When using a gasket or tape, the cap layer 4 may be kept in contact with the first surface 2a of the manifold 102 using screws, springs, or another locking system. The function of cap layer 4 is to sealing of the channels realized in the manifold and on the other side it can create a preferred path for the fluid in the manifold to access only selective parts of the sub-coldplate according to the desired result. Cap layer 4 may comprise a plastic material such as PMMA, Polycarbonate, PVC, PEEK, Nylon, HDPE, or a metal such as aluminium, steel, copper, invar, Kovar. The cap layer 4 has a first opening 4a and a second opening 4b defined therein (as can also be seen in Figure 8d). The first opening 4a is fluidically connected to the main-input-channel 81c; the second opening 4b is fluidically connected to the main-output-channel 5d. Cooling fluid can be passed into the main-input-channel 81c through the first opening 4a and cooling fluid can pass from the main-output-channel 5d into the second opening 4b.

During use cooling fluid may be provided into the main-input channel 81c via the first opening 4a in the cap layer 4. The cooling fluid will flow from the main-input-channel 81 into the two subsidiary input channels 81a,81b; and from the two subsidiary input channels 81a,81b through the two inlets 89a,89b, and into each of the channels 6a-6h in the sub-coldplate 3. Accordingly, each of the channels 6a-6h in the sub coldplate 3 will receive a portion of the cooling fluid which was provided into the main-input-channel 81. The cooling fluid will flow along the channels 6a-6h in the sub-coldplate 3 and into the three outlets 88a-88c in the manifold 2. The cooling fluid will then flow from the three outlets 88a 88c into the subsidiary output channels 5a-5c, and from subsidiary output channels 5a-5c into the main-output-channel 5d. The plurality of pillars 87 will help to improve heat transfer from the manifold 2 to the cooling fluid 25 which is flowing through main-output-channel 5d.

In a preferred embodiment, the cooling fluid will then flow from the main-output-channel 5d into a collection reservoir, and/or a heat exchanger, via the second opening 4b in the cap layer 4. So in an embodiment the cooling assembly 80 may further comprise a reservoir, and/or a heat exchanger, which can receive cooling fluid which is discharged from the main-output-channel 5d in the manifold 2.

In an embodiment of the cooling assembly 80 there is an intermediate layer interposed between the sub-coldplate 3 and the manifold 2. The intermediate layer preferably comprises glass. The intermediate layer may comprise any of the features of the intermediate layer described for the cooling assembly 1 and/or any variations described in the present application. An adhesive maybe used to attach the sub coldplate 3 to one surface of the glass layer and an adhesive may be used to attach the manifold 2 to an opposite surface of the glass layer; in a preferred embodiment the sub-coldplate is attached to the glass layer by means of a wafer bond, which can be formed through a process such as anodic bonding, which directly bonds the sub-coldplate 3 to the glass layer using electricity. Advantageously, the surfaces of the glass layer have low surface roughness thereby allowing for good adhesion to the sub-coldplate 3 and manifold 2; in other words the use of an intermediate glass layer enables the positions of sub-coldplate 3 and manifold 2 to be more securely fixed. It should be understood that the intermediate layer may be composed of any suitable material; for example the intermediate layer may comprise any one or more of glass, silicon, copper, molybdenum, aluminium nitride, aluminium oxide, nickel-iron alloys, nickel-iron-cobalt alloys and aluminium-silicon alloys, Hastelloy or Inconel; but the intermediate layer preferably comprises glass. The intermediate layer will comprise respective cutouts which have dimensions equal to, or substantially equal to, the dimensions of the respective inlets 89a,89b and outlets 88a-d; and those cutout will be aligned with the respective inlets 25 89a,89b and outlets 88a-d 8a so that the intermediate layer does not obstruct the flow of cooling fluid between the sub-coldplate 3 and the manifold 2.

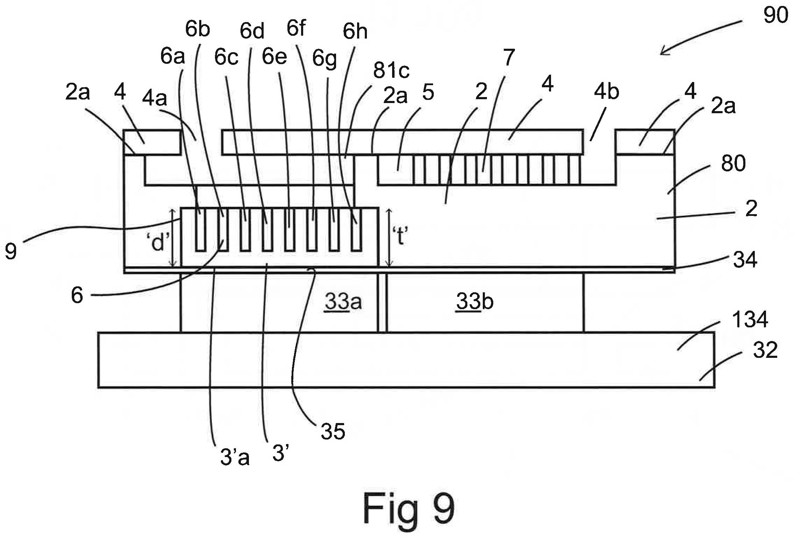

Figure 9 illustrates a longitudinal section view of semiconductor assembly 90 according to an embodiment of the present invention. It should be understood that the semiconductor assembly 90 may comprise any of the features of any of the other semiconductor assembly embodiments described in the present application.

The semiconductor assembly 90 comprises the cooling assembly 80 of Figure 8a and like features are awarded the same reference numbers. The semiconductor assembly 90 further comprises a chip assembly 32 which comprises a PCB 134 and a plurality of semiconductor components 33 mounted on the PCB 134. In this example the semiconductor assembly 90 comprises a first semiconductor component 33a which is known to produce a heat flux which is above a predefined threshold heat flux when the chip assembly 32 is in use, and a second semiconductor component 33b which is known to produce a heat flux which is below the predefined threshold heat flux when the chip assembly 32 is in use.

In this embodiment each of semiconductor components 33a,33b have equal height 'h'. In another embodiment the height 'h' of each of the semiconductor components 33a,33b may not be equal (due to manufacturing tolerances for example) however the difference between the height of one of the first semiconductor component 33a and the second semiconductor component 33b is preferably not more than 0 micrometers.

The cooling assembly 80 is mounted on the chip assembly 32, and the sub-coldplate 3 is aligned with, and thermally connected to a first semiconductor component 33a, and the manifold 2 is thermally connected to second semiconductor component 33b. More specifically, the sub coldplate 3 is aligned with and thermally connected to, the first semiconductor component 33a which is known to produce a heat flux which is above a predefined threshold heat flux when the chip assembly 32 25 is in use; the manifold 2 is thermally connected to the second semiconductor component 33b which is known to produce a heat flux which is below the predefined threshold heat flux when the chip assembly 32 is in use. Specifically, in this embodiment, the main-output-channel 5d in the manifold 2 are aligned over the second semiconductor component 33b. The dimensions of the surface 3a of the sub-coldplate 3 which is facing away from the manifold 2 is equal to the dimension of a surface 35 of the first semiconductor component 33a which is facing towards the cooling assembly 80.

The semiconductor assembly further comprises a thermal interface material layer 34 which is interposed between the first semiconductor component 33a and the sub-coldplate 6 and is also interposed between the second semiconductor component 33b and the manifold 2. Preferably the thermal interface material layer 34 covers the whole of the second surface 2b of the manifold 2.

During use cooling fluid is provided into the main-input-channel 81c via the first opening 4a in the cap layer 4. The cooling fluid will flow from the main-input-channel 81c into the two subsidiary input channels 81a,81b; and from the two subsidiary input channels 81a,81b through the two inlets 89a,89b, and into each of the channels 6a-6h in the sub-coldplate 3. Accordingly, each of the channels 6a-6h in the sub-coldplate 3 will receive a portion of the cooling fluid that was provided into the main input-channel 81c. The cooling fluid will flow along the channels 6a-6h in the sub-coldplate 3. As the cooling fluid flows along the channels 6a-6h in the sub-coldplate 3 the cooling fluid will absorb heat from the sub coldplate 3 which the sub-coldplate 3 has conducted away from the first semiconductor component 33a. Pillars and/or fins that may be located within the channels 6a-6h in the sub-coldplate 3 may help to improve heat transfer from the sub-coldplate 3 into the cooling fluid.

The cooling fluid will flow from each of the channels 6a-6h in the sub-coldplate 3 into the three outlets 88a-88c in the manifold 2. The cooling fluid will then flow from the three outlets 88a-88c into the subsidiary output channels 5a-5c, and then into the main-output-channel 5d. As the cooling fluid flows along the main-output-channel 5d it will contact the pillars 87 that are located in the main-output-channel 5d. As the cooling fluid flows along the main-output-channel 5d in the manifold 2 the cooling fluid absorbs heat from the manifold 2 which the manifold 2 has conducted away from the second semiconductor component 33b. The plurality of pillars 87 will help to improve heat transfer from the manifold 2 to the cooling fluid which is flowing through main-output-channel 5d.

In a preferred embodiment, the cooling fluid will then flow from the main-output-channel 5d into an external collection reservoir, and/or a heat exchanger, via the second opening 4b in the cap layer 4.

In other words heat produced by the first semiconductor component 33a is conducted into the sub-coldplate 3, and that heat is absorbed by the cooling fluid when it flows through the channels 6a-6h in the sub-coldplate 3; heat produced by the second semiconductor component 33b is conducted into the manifold 2 and also into the pillars 87 of the manifold 2, and that heat is absorbed by the cooling fluid when it flows through the main output channel 5d in the manifold 2. The heated cooling fluid is then preferably dispensed from the channels 5 into a reservoir and/or a heat exchanger.

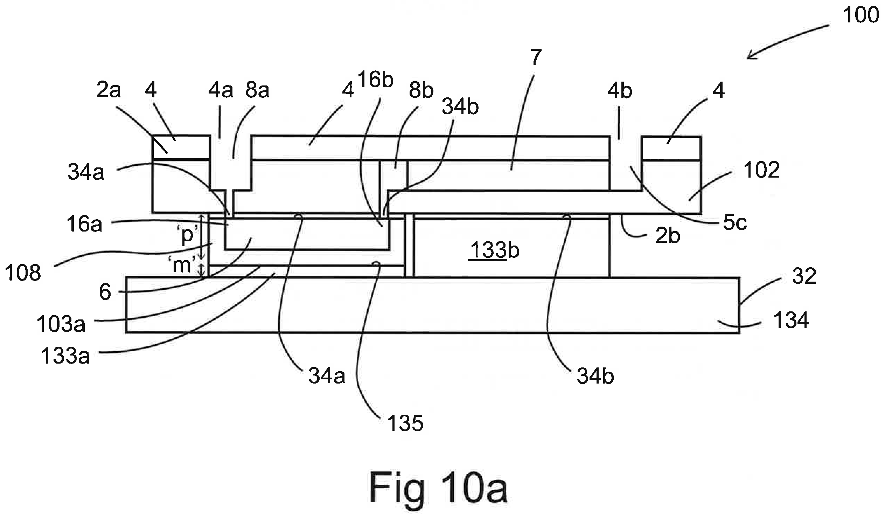

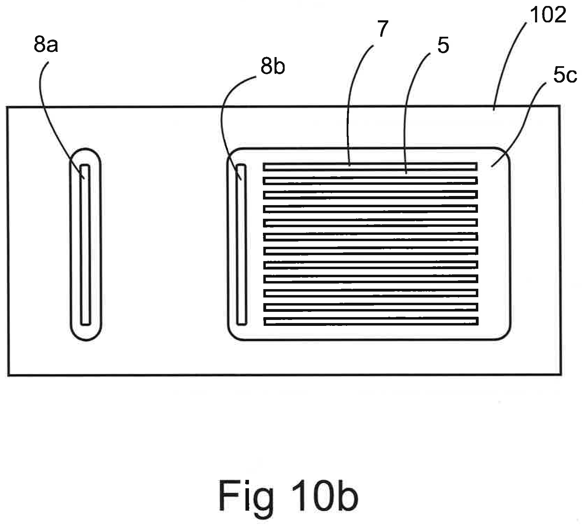

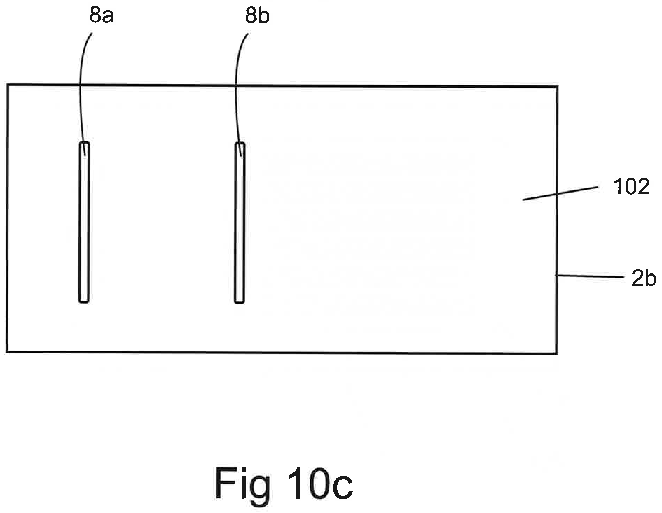

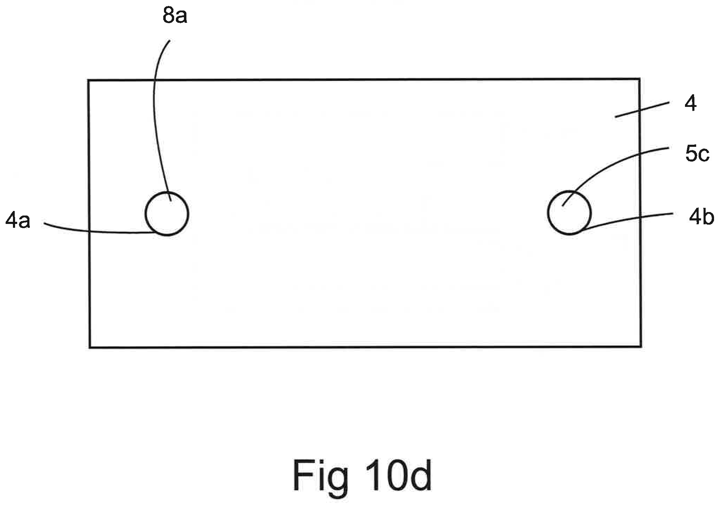

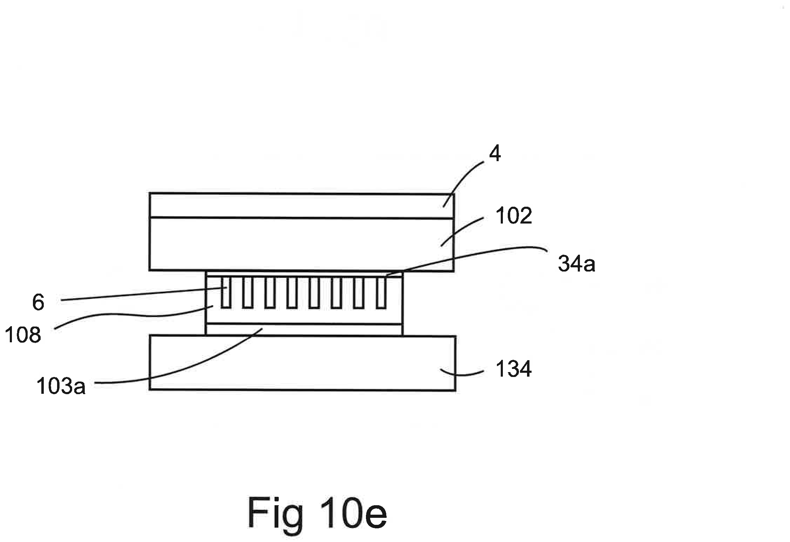

Figure 10 illustrates a longitudinal section view of semiconductor assembly 100 according to an embodiment of the present invention; Figure 10b shows a top view of a manifold 102 used in the semiconductor assembly 100; Figure 10c shows a bottom view of the manifold 102; and Figure 10d shows a top view of the semiconductor assembly 100; Figure 10e shows a cross sectional view taken along line A-A' of figure 10a. It should be understood that the semiconductor assembly 100 may comprise any of the features of any of the other semiconductor assembly embodiments described in the present application.

The semiconductor assembly 100 comprises a chip assembly 32 which comprises a PCB 134 and a plurality of semiconductor components 133a,133b mounted on the PCB 134. Specifically, the semiconductor assembly 100 comprises a first semiconductor component 133a which is known to produce a heat flux which is above a predefined threshold heat flux when the chip assembly 32 is in use; and a second semiconductor component 133b which is known to produce a heat flux which is below said predefined threshold heat flux when the chip assembly 32 is in use.

The first semiconductor component 133a has an integral cooling plate 108. Specifically, the first semiconductor component 133a has a layer 108 (which preferably comprises silicon) which is mounted on, and thermally connected to, the first semiconductor component 133a, and a cooling channel 6, along which cooling fluid can flow, is defined in that layer 108; this layer 108 with a cooling channel 6 defines the cooling plate 108 which is thermally connected to the first semiconductor component 133a. So, the cooling plate 108 is thermally connected to, the first semiconductor component 133a which is known to produce a heat flux which is above a predefined threshold heat flux when the chip assembly 32 is in use. In another embodiment first semiconductor component 133a is formed in a substrate (e.g. a silicon substrate), and the cooling channel 6 are defined in the said same substrate; in this embodiment the cooling plate 108 and the first semiconductor component 133a are completely integrated in the same substrate (e.g. a silicon substrate).In a preferred embodiment the cooling plate 108 comprises silicon. The cooling plate 108 will be composed of the same material as the first semiconductor component 133a.

In this embodiment the height 'h' of the second semiconductor component 133b is equal to the combined total height of the first semiconductor component 133a plus the height 'p' of the of the cooling plate 108 (i.e. h=m+p). In another embodiment the 'h' of the second semiconductor component 133b is not precisely equal to the combined total height 'm' of the first semiconductor component 133a plus the height 'p' of the of the cooling plate 108 (due to manufacturing tolerances for example), however difference between the height 'h' and the combined total height 'm' + 'p' is preferably not more than 150micrometers (i.e. the different between the absolute value of 'h' and the absolute value of 'm+p' is less than 150 micrometers).

Most preferably the area dimensions of a surface 103a of the cooling plate 108 which is attached to the first semiconductor component 133a is equal to the area dimensions of a surface 135 of the first semiconductor component 133a to which the cooling plate 108 is attached. Typically, the area dimensions of the surface 103a of the cooling plate 108 which is attached to the first semiconductor component 133a, is in the range 1mm*1mm-250mm*250mm; and is preferably in the range 2mm*2mm-50*50 mm; and it most preferably in the range 5mm*5mm 30mm*30mm.

The cooling plate 108 can have one or more channels 6 defined therein along which cooling fluid can flow. In this example the cooling plate 108 has a plurality of channels 6 defined therein (as can be best seen in Figure 10e). Each of the channels 6 has a respective inlet 16a which is at one end of the channel 6, and a respective outlet 16b which is the opposite end of the channel 6. In another embodiment the cooling plate 108 may have a single channel (e.g. a single meandering channel) defined therein; the single channel may have a single inlet which is at one end of the single channel, and a single outlet which is an opposite end of the channel.

The semiconductor assembly 100 further comprises a manifold 102. The manifold 102 has one or more channels 5 defined therein. Cooling fluid can be selectively flowed along the one or more channels 5 in the manifold 2. In this embodiment the manifold 2 comprises a plurality of fins 7 which define a plurality of parallel channels 5. The manifold 102 comprises a first surface 2a and a second, opposite, surface 2b. Preferably 25 the channels 5 of the manifold 102 are defined in the first surface 2a of the manifold 102. In this embodiment preferably the second opposite surface 2b is planar (flat).

At one end each of the plurality of parallel channels 5 is fluidically connected to a single outlet 8b which is defined in the manifold 102; and a second opposite end each of the plurality of parallel channels 5 is fluidically connected to an end-channel-portion 5c (so cooling fluid can flow from the single outlet 8b, along the channels 5, and into the end channel-portion 5c). The manifold 102 further comprises a single inlet 8a defined therein.

Each of the respective channels 6 in the cooling plate 108 is fluidically connected to the inlet 8a and outlet 8b in the manifold 102; specifically the inlet 16a of the respective channel 6 is fluidically connected to the inlet 8a of the manifold 102, and the outlet 16b of the respective channel 6 is fluidically connected to the outlet 8b of the manifold 102. Fluid can flow through the inlet 8a in the manifold 102, into and along the channels 6 in the cooling plate 108, and then through the outlet 8b and into the channels 5 in the manifold 102.

The semiconductor assembly 100 further comprises a cap layer 4 which is attached to the first surface 2a of the manifold 102. Cap layer 4 may comprise any one or more of, a plastic material such as PMMA, Polycarbonate, PVC, PEEK, Nylon, HDPE, and/or a metal such as aluminum, steel, copper, invar, and/or Kovar. The cap layer 4 has a first opening 4a and a second opening 4b defined therein (as can also be seen in Figure 10d). The first opening 4a is aligned over the inlet 8a of the manifold 102 and the second opening 4b is aligned over an end-channel-portion 5c of the channel 5. Cooling fluid can be passed into the inlet 8a through the first opening 4a and cooling fluid can pass from the end-channel-portion 5c into the second opening 4b. Not only can the first opening 4a and a second opening 4b may define ports to serve as an inlet and outlet for cooling fluid, but the first opening 4a and a second opening 4b may further serve as threads, fluidic connectors, fittings, cavities for o-rings or other gaskets, and/or as alignment features. The cap layer 4 can be attached to the first surface 2a of the manifold 102 such that it creates a leak tight seal using gaskets, tape, glue, soldering or brazing. When using a gasket or tape, the cap layer 4 may be kept in contact with the first surface 2a of the manifold 102 using screws, springs, or another locking system. A function of cap layer 4 may be to provide a roof (i.e. to close from above) the channel 5 defined in the manifold 2; another function of the cap layer 4 may be and create a preferred flow path for the cooling fluid in the manifold so that the cooling fluid flows from the channels 5 in the manifold into a predefined selection of the channels 6 defined in the cooling plate 108.

The semiconductor assembly 100 further comprises a thermal interface material layer 34 which is between the manifold 102 and the cooling plate 108 and is also between the manifold 102 and the second semiconductor component 133b. Preferably the interface material layer 34 forms a leak-tight seal between the cooling plate 108 and the manifold 102. The interface material layer 34 may, for example, be attached to the cooling plate 108 and the manifold 102 by means of, eutectic bonding, an epoxy, glass frit, and/or low temperature soldering. In preferred embodiment a portion 34a of the thermal interface material layer 34 which is located between the manifold 102 and the cooling plate 108 of may comprise any one or more of, an epoxy, solder joint, eutectic joint, glass frit, tin or indium alloy, tape and/or adhesive; a portion 34b of the thermal interface material layer 34 which is located between the manifold 102 and the second semiconductor component 133b may comprise any one or more of, thermally-conductive material (such as a thermal interface material), a thermal pad, and/or tape.

During use cooling fluid is provided into the inlet 8a in the manifold 102, via the first opining 4a in the cap layer 4. The cooling fluid flows through the inlet 8a in the manifold 102 and into the channels 6 in the cooling plate 108; the cooling fluid flows along the channels 6 in the cooling plate 108 absorbing heat from the cooling plate 108 which the cooling plate 108 has conducted away from the first semiconductor component 133a. Pillars and/or fins that may be located within the channels 6 in the cooling plate 108 to help to improve heat transfer from the cooling plate 108 to the cooling fluid.

The cooling fluid then flows from the channels 6 in the cooling plate 108 into the outlet 8b in the manifold 102, and from the outlet 8b into the channels 5 in the manifold 102. As the cooling fluid flows through the channels 5 in the manifold 102 the cooling fluid absorbs heat from the manifold 102 which the manifold 102 has conducted away from the second semiconductor component 133b. The fins 7 in the manifold 2 will help to improve heat transfer from the manifold 102 into the cooling fluid which is flowing through the channels 5. The cooling fluid will flow along the channels 5 to the end-channel-portion 5c. The heated cooling fluid is then preferably dispensed from the end-channel-portion 5c into a reservoir and/or a heat exchanger.

In other words heat produced by the first semiconductor component 133a is conducted into the cooling plate 108 which is integral to the first semiconductor component 133a, and that heat is absorbed by the cooling fluid when it flows through the channels 6 in the cooling plate 8; heat produced by the second semiconductor component 133b is conducted into the manifold 102 and also into the fins 7 of the manifold 2, and that heat is absorbed by the cooling fluid when it flows through the channels 5 in the manifold 2. The heated cooling fluid is then preferably dispensed into a reservoir and/or a heat exchanger.

According to a further aspect of the present invention there is provided a method of producing a cooling assembly; for example a method of producing any of the cooling assembly embodiments described above. The method preferably comprises the steps of,
providing a chip assembly which comprises a plurality of semiconductor components;
determining the heat flux which is produced by each of the semiconductor components when the chip assembly is in use; identifying which semiconductor components produce a heat flux which is above a predefined threshold heat flux and identifying which semiconductor component produce a heat flux which is below said predefined threshold heat flux;
providing a manifold;
attaching one or more sub-coldplates to the manifold, wherein the location of the sub-coldplates on the manifold correspond to the locations of the semiconductor components in the chip assembly which produce a heat flux which is above a predefined threshold heat flux.

In a preferred embodiment the location of the sub-coldplates on the manifold mirror the locations of the semiconductor components in the chip assembly which produce a heat flux which is above a predefined threshold heat flux.

In the preferred embodiment, the manifold 2 comprises a first surface 2a and a second, opposite, surface 2b, and the method comprises the steps of,forming one or more pockets in the manifold, each of which can receive a respective sub-coldplate, wherein the location of the pockets correspond to (e.g. mirror) the locations of the semiconductor components in the chip assembly which produce a heat flux which is above a predefined threshold heat flux; and inserting a respective sub-coldplate into a respective pocket.

In one embodiment the step of forming one or more pockets in the manifold comprises, forming one or more pockets which each have a depth 'd' which is less than the thickness 't' of each sub-coldplate, so that when the a respective sub-coldplate is inserted into a respective pocket the sub-coldplate will project from the respective pocket; and the method further comprises a step of polishing the part of each respective sub coldplate which projects from its respective pocket until the surface of each respective sub-coldplate which is facing away from the manifold 2 is flush with the second surface 2b of the manifold 2.

In another embodiment the step of forming one or more pockets in the manifold comprises forming one or more pockets which each have a depth 'd' which is equal to the thickness 't' of each sub-coldplate, so that when the a respective sub-coldplate is inserted into a respective pocket the surface of each respective sub-coldplate which is facing away from the manifold 2 is flush with the second surface 2b of the manifold 2.

It should be understood that the step of determining the heat flux which is produced by each of the semiconductor components when the chip assembly is in use, can be performed using known techniques in the art.

Each of the one or more sub-coldplates is preferably attached to the manifold via a leak-tight attachment. In a preferred embodiment each of the one or more sub-coldplates is attached to the manifold via a metallic bond (e.g. soldering medium) which forms said leak-tight attachment; the metallic bond (e.g. soldering medium) may be formed using a low melting metal like Indium, Tin, Gold Gallium, Bismuth, Lead or alloys of these, or similar metals. The metal can be in the form of a wire, a thin layer or a paste dispensed around the passage of the fluid and reflow to form an intermetallic. A thin metallic layer can be deposited on a surface of the sub coldplate to increase wettability of the soldering medium. In another embodiment, a glue may be used to attach the each of the one or more sub-coldplates to the manifold (i.e. the glue forms said leak-tight attachment between the sub-coldplates and manifold). In another embodiment, a polymer may be used to attach the each of the one or more sub-coldplates to the manifold (i.e. the polymer forms said leak-tight attachment between the sub-coldplates and manifold); the polymer may be in the form of O-rings or pre-cut deformable pads. In an embodiment (e.g. in an embodiment wherein a polymer is used to attach the each of the one or more sub-coldplates to the manifold) preferably each of the one or more sub-coldplates is held in contact with the manifold using a suitable fastening means such as screws, springs, or any other suitable fastening means. In another embodiment, glass-frit may be used to attach the each of the one or more sub-coldplates to the manifold (i.e. the glass-frit forms said leak-tight attachment between the sub-coldplates and manifold).

According to a further aspect of the present invention there is provided a method of producing a semiconductor assembly. For example of producing any of the semiconductor assembly embodiments described above. The method preferably comprises the steps of:
providing a chip assembly which comprises a plurality of semiconductor components;
determining the heat flux which is produced by each of the semiconductor components when the chip assembly is in use; identifying which semiconductor components produce a heat flux which is above a predefined threshold heat flux and identifying which semiconductor component produce a heat flux which is below said predefined threshold heat flux;
forming a cooling assembly according to any of the above mentioned cooling assembly embodiments, wherein the location of the sub-coldplates on the manifold correspond to the locations of the semiconductor components in the chip assembly which produce a heat flux which is above a predefined threshold heat flux;
mounting the cooling assembly on the chip assembly so that the sub-coldplates are aligned with and thermally contact the semiconductor components in the chip assembly which produce a heat flux which is above a predefined threshold heat flux and the manifold thermally contacts the semiconductor components in the chip assembly which produce a heat flux which is below the predefined threshold heat flux.

In a preferred embodiment the location of the sub-coldplates on the manifold mirror the locations of the semiconductor components in the chip assembly which produce a heat flux which is above a predefined threshold heat flux.

In an embodiment the step of forming a cooling assembly comprises the steps of, producing a manifold which has a plurality of pockets defined therein, wherein the location of the pockets correspond to (e.g. mirror) the locations of the semiconductor components in the chip assembly which produce a heat flux which is above a predefined threshold heat flux; and inserting a respective sub-coldplate into a respective pocket in the manifold. In one embodiment the step of forming one or more pockets in the manifold comprises, forming one or more pockets which each have a depth which is less than the thickness 't' of each sub-coldplate, so that when the a respective sub-coldplate is inserted into a respective pocket the sub-coldplate will project from the respective pocket; and the method the preferably further comprises a step of polishing the part of each respective sub-coldplate which projects from its respective pocket until the surface of each respective sub-coldplate which is facing away from the manifold 2 is flush with the second surface 2b of the manifold 2. In another embodiment the step of forming one or more pockets in the manifold comprises forming one or more pockets which each have a depth which is equal to the thickness 't' of each sub-coldplate, so that when the a respective sub-coldplate is inserted into a respective pocket the surface of each respective sub-coldplate which is facing away from the manifold 2 is flush with the second surface 2b of the manifold 2.

Preferably the method further comprises a step of providing a thermal interface material between the sub-coldplates and the semiconductor components, and providing a thermal interface material between the manifold and the semiconductor components.

It should be understood that the step of determining the heat flux which is produced by each of the semiconductor components when the chip assembly is in use, can be performed using known techniques in the art.

Various modifications and variations to the described embodiments of the invention will be apparent to those skilled in the art without departing from the scope of the invention as defined in the appended claims. Although the invention has been described in connection with specific preferred embodiments, it should be understood that the invention as claimed should not be unduly limited to such specific embodiment.

The following items provide exemplary embodiments of the present disclosure:
Item 1:A cooling assembly for use as a heat sink in a semiconductor assembly, the cooling assembly comprising,
   a manifold having one or more channels defined therein along which cooling fluid can flow;
   one or more sub-coldplates which are each attached to the manifold, wherein each of the sub-coldplates have one or more channels defined therein along which cooling fluid can flow; and
   wherein the one or more channels in the manifold are fluidically connected to the one or more channels in the one or more sub-coldplates so that cooling fluid can flow from the one or more channels in the manifold to the one or more channels in the one or more sub-coldplates; and
   wherein the manifold comprises a first surface and a second, opposite, surface, and wherein a surface of each the respective one or more sub coldplates which is facing away from the manifold is flush with the second surface of the manifold, so that both the second surface of the manifold and the one or more sub-coldplates can be arranged to thermally contact respective semiconductor components.
Item 2:A cooling assembly according to item 1, wherein the manifold has one or more pockets defined therein and wherein each sub-coldplate is located in a respective pocket; and wherein the depth of each pocket is equal to the thickness of each sub-coldplate so that the surface of each sub coldplate which is facing away from the manifold is flush with the second surface of the manifold.
Item 3:A cooling assembly according to item 1 or 2, wherein the sub-coldplates comprise silicon.
Item 4:A cooling assembly according to any one of the preceding items wherein there is a layer of glass interposed between each sub-coldplate and the manifold.
Item 5:A cooling assembly according to any one of the preceding items wherein one or more pillars and/or fins are located within the one or more channels in the manifold.
Item 6:A cooling assembly according to any one of the preceding items wherein the manifold further comprises a drain channel into which the one or more channels defined in the manifold are fluidically connected; and wherein the drain channel is fluidically connected to a channel in a sub coldplate so that cooling fluid can flow from the channels defined in the manifold into the drain channel, and from the drain channel into the channel in the sub-coldplate; and
   wherein the manifold further comprises a receiving channel which is fluidically connected to the one or more channels defined in the manifold; and wherein the receiving channel is fluidically connected to the channel in a sub-coldplate so that cooling fluid can flow from the channel in the sub coldplate to the receiving channel.
Item 7:A cooling assembly according to any one of the preceding items wherein the one or more channels defined in the manifold comprise an inlet and an outlet, wherein the outlet is fluidically connected to a reservoir and/or a heat exchanger.
Item 8:A cooling assembly according to any one of the preceding items wherein said one or more channels are defined in the first surface of the manifold.
Item 9:A cooling assembly according to any one of the preceding items wherein the cooling assembly further comprises a cap layer which is on the first surface of the manifold.
Item 10: A cooling assembly according to any one of the preceding items wherein the dimensions of a surface of each sub-coldplate which is facing away from the manifold is in the range of 1mm*1mm- 250mm*250mm, preferably 2x2 mm to 50x50 mm, most preferably 5mm*5mm 30mm*30mm.
Item 11: A method of producing a cooling assembly according to item 1, the method comprising the steps of providing a chip assembly which comprises a plurality of semiconductor components; determining the heat flux which is produced by each of the
   semiconductor components when the chip assembly is in use; identifying which semiconductor components which produce a heat flux which is above a predefined threshold heat flux and identifying which semiconductor component produce a heat flux which is below said predefined threshold heat flux;
   providing a manifold;
   attaching one or more sub-coldplates to the manifold, wherein the location of the sub-coldplates on the manifold correspond to the locations of the semiconductor components in the chip assembly which produce a heat flux which is above a predefined threshold heat flux.
Item 12: A method according to item 11, wherein the manifold comprises a first surface and a second, opposite, surface, and wherein the method comprises the steps of,
   forming one or more pockets in the manifold, each of which can receive a respective sub-coldplate, wherein the location of the pockets correspond to the locations of the semiconductor components in the chip assembly which produce a heat flux which is above a predefined threshold heat flux; inserting a respective sub-coldplate into a respective pocket.
Item 13: A method according to item 11 or 12 wherein the step of forming one or more pockets in the manifold comprises forming one or more pockets which each have a depth which is less than the width of a sub-coldplate, so that when the a respective sub-coldplate into a respective pocket the sub coldplates will project from the respective pocket; and wherein the method further comprises a step of polishing the sub-coldplate so that a surface of each the respective one or more sub-coldplates which is facing away from the manifold is flush with the second surface of the manifold.
Item 14: A method according to item 11 or 12 wherein the step of forming one or more pockets in the manifold comprises forming one or more pockets which each have a depth which is equal to the width of a sub-coldplate, so that when the a respective sub-coldplate is insterted into a respective pocket a surface of each the respective one or more sub-coldplates which is facing away from the manifold is flush with the second surface of the manifold.
Item 15: A semiconductor assembly comprising, a chip assembly which comprises a plurality of semiconductor components;
   a cooling assembly according to item 1 which is mounted on the chip assembly, and wherein the/each sub-coldplate is aligned with, and thermally connected to, a respective semiconductor component; and wherein the manifold is thermally connected to one or more semiconductor components.
Item 16: A semiconductor assembly according to item 15, wherein the/each sub coldplate is aligned with and thermally connected to, a respective semiconductor component which is known to produce a heat flux which is above a predefined threshold heat flux when the chip assembly is in use; and wherein the manifold is thermally connected to one or more semiconductor components which is/are known to produce a heat flux which is below the predefined threshold heat flux when the chip assembly is in use.
Item 17: A semiconductor assembly according to item 15 or 16, wherein the plurality of semiconductor components have the equal height.
Item 18: A semiconductor assembly according to any one of items 15-17, wherein the semiconductor assembly further comprises a thermal interface material interposed between the semiconductor component(s) and the sub coldplate(s) and between the semiconductor component(s) and the manifold.
Item 19: A semiconductor assembly according to any one of items 15-18, wherein dimensions of a surface of each sub-coldplate which is facing away from the manifold is equal to the dimensions of a surface of the respective semiconductor component which is facing towards the cooling assembly.
Item 20: A method of producing a semiconductor assembly according to item 15, the method comprising the steps of
   providing a chip assembly which comprises a plurality of semiconductor components;
   determining the heat flux which is produced by each of the
   semiconductor components when the chip assembly is in use; identifying which semiconductor components which produce a heat flux which is above a predefined threshold heat flux and identifying which semiconductor component produce a heat flux which is below said predefined threshold heat flux;
   forming a cooling assembly according to item 1, wherein the location of the sub-coldplates on the manifold correspond to the locations of the 20 semiconductor components in the chip assembly which produce a heat flux which is above a predefined threshold heat flux;
   mounting the cooling assembly on the chip assembly so that the sub coldplates are aligned with and thermally contact the semiconductor components in the chip assembly which produce a heat flux which is above
   a predefined threshold heat flux and the manifold thermally contacts the semiconductor components in the chip assembly which produce a heat flux which is below the predefined threshold heat flux.
Item 21: A method according to item 20 further comprising the steps of, producing a manifold which has a plurality of pockets defined therein, wherein the location of the pockets correspond to the locations of the semiconductor components in the chip assembly which produce a heat flux which is above a predefined threshold heat flux; inserting a respective sub coldplate into a respective pocket in the manifold.
Item 22: A method according to item 20 or 21 further comprising the step of providing a thermal interface material between the sub-coldplates and the semiconductor components, and providing a thermal interface material between the manifold and the semiconductor components.
Item 23: A semiconductor assembly comprising,
   a chip assembly which comprises a plurality of semiconductor components, wherein at least one of the semiconductor components comprises a layer in which one or more cooling channels along with cooling fluid can flow, are defined, and at least one other of the semiconductor components is without cooling channels;
   a manifold having one or more channels defined therein along which cooling fluid can flow;
   wherein the one or more channels in the manifold are fluidically connected to the one or more channels in said at least one semiconductor component, so that cooling fluid can flow from the one or more channels in the manifold to the one or more channels in the one or more in said at least one semiconductor component; wherein the manifold is thermally connected to one or more of said semiconductor components which are without cooling channels.
Item 24: A semiconductor assembly according to item 23, wherein the height of the plurality of semiconductor components is equal; and wherein the manifold comprises a first surface and a second, opposite, surface, wherein the one or more channels are defined in the first surface, and wherein the second surface is planar.
Item 25: A semiconductor assembly according to item 23 or 24 wherein the manifold is thermally connected to semiconductor components which produce a heat flux which is below the predefined threshold heat flux when the chip assembly is in use; and the wherein the at least one of semiconductor component which comprises a layer in which one or more cooling channels are defined, is a semiconductor component which produces a heat flux which is above the predefined threshold heat flux when the chip assembly is in use.

## Claims

1. A semiconductor assembly comprising,
a chip assembly which comprises a plurality of semiconductor components,
wherein at least one of the semiconductor components comprises a layer in which one or more cooling channels along with cooling fluid can flow, are defined, and at least one other of the semiconductor components is without cooling channels;
a manifold having one or more channels defined therein along which cooling fluid can flow;
wherein the one or more channels in the manifold are fluidically connected to the one or more channels in said at least one semiconductor component, so that cooling fluid can flow from the one or more channels in the manifold to the one or more channels in said at least one semiconductor component; wherein the manifold is thermally connected to one or more of said semiconductor components which are without cooling channels.

2. The semiconductor assembly according to claim 1, wherein the height of the plurality of semiconductor components is equal; and wherein the manifold comprises a first surface and a second, opposite, surface, wherein the one or more channels are defined in the first surface, and wherein the second surface is planar.

3. The semiconductor assembly according to claim 1 or 2 wherein the manifold is thermally connected to semiconductor components which produce a heat flux which is below a predefined threshold heat flux when the chip assembly is in use; and wherein the at least one of the semiconductor components which comprises a layer in which one or more cooling channels are defined, is a semiconductor component which produces a heat flux which is above the predefined threshold heat flux when the chip assembly is in use.

4. The semiconductor assembly according to any of claims 1-3,
wherein the at least one of the semiconductor components which comprises a layer in which one or more cooling channels are defined is formed in a substrate and the one or more cooling channels are defined in said same substrate.

5. The semiconductor assembly according to claim 4,
wherein the substrate is a silicon substrate.

6. The semiconductor assembly according to claim 4 or 5,
wherein the layer forms a cooling plate of the at least one of the semiconductor components comprising said layer.

7. The semiconductor assembly according to claim 6,
wherein the cooling plate and the at least one of the semiconductor components which comprises a layer in which one or more cooling channels are defined are completely integrated in said same substrate.

8. The semiconductor assembly according to claim 6 or 7,
wherein the cooling plate has a plurality of channels defined therein, each of the channels has a respective inlet which is at one end of the channel, and a respective outlet which is the opposite end of the channel; or
wherein the cooling plate has a single channel defined therein, in particular a single meandering channel, and the single channel has a single inlet which is at one end of the single channel, and a single outlet which is an opposite end of the single channel.

9. The semiconductor assembly according to any of claims 6 to 8,
wherein the semiconductor assembly further comprises a thermal interface material layer which is between the manifold and the cooling plate and is also between the manifold and the one or more of said semiconductor components which are without cooling channels.

10. The semiconductor assembly according to claim 9,
wherein the interface material layer forms a leak-tight seal between the cooling plate and the manifold.

11. The semiconductor assembly according to any of claims 6 to 10,
wherein pillars and/or fins are located within the channels in the cooling plate to help to improve heat transfer from the cooling plate to the cooling fluid.

12. The semiconductor assembly according to any of the previous claims,
wherein the manifold comprises a plurality of fins which define a plurality of parallel channels.

13. The semiconductor assembly according to claim 12,
wherein at one end each of the plurality of parallel channels is fluidically connected to a single outlet which is defined in the manifold; and at a second opposite end each of the plurality of parallel channels is fluidically connected to an end-channel-portion, so that cooling fluid can flow from the single outlet, along the channels, and into the end channel-portion.

14. The semiconductor assembly according to any of the previous claims,
wherein the manifold comprises a first surface and a second, opposite, surface and the semiconductor assembly further comprises a cap layer which is attached to the first surface of the manifold.

15. The semiconductor assembly according to claims 13 and 14,
wherein the cap layer has a first opening and a second opening defined therein and the first opening is aligned over an inlet of the manifold and the second opening is aligned over the end-channel-portion.
